(19) Europäisches Patentamt / European Patent Office / Office européen des brevets

(11) **EP 2 440 024 B1**

(12) **EUROPEAN PATENT SPECIFICATION**

(45) Date of publication and mention
of the grant of the patent:
**12.03.2014 Bulletin 2014/11**

(21) Application number: **10783253.7**

(22) Date of filing: **18.05.2010**

(51) Int Cl.:
*H05K 3/32* (2006.01)     *H05K 3/36* (2006.01)
*H05K 3/28* (2006.01)     *H05K 3/30* (2006.01)
*H05K 3/34* (2006.01)

(86) International application number:
**PCT/JP2010/058356**

(87) International publication number:
**WO 2010/140469 (09.12.2010 Gazette 2010/49)**

(54) **CONNECTION METHOD**

VERBINDUNGSVERFAHREN

PROCÉDÉ DE CONNEXION

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **01.06.2009   JP 2009132076
02.06.2009   JP 2009132754
05.06.2009   JP 2009135872**

(43) Date of publication of application:
**11.04.2012   Bulletin 2012/15**

(60) Divisional application:
**11192441.1 / 2 453 726
11192444.5 / 2 445 322**

(73) Proprietors:
• **Sumitomo Electric Industries, Ltd.**
**Chuo-ku**
**Osaka-shi**
**Osaka 541-0041 (JP)**
• **Sumitomo Electric Printed Circuits, Inc.**
**Kouga-shi**
**Shiga 528-0068 (JP)**

(72) Inventors:
• **Yamamoto, Masamichi**
**Osaka-shi**
**Osaka 554-0024 (JP)**
• **Nakatsugi, Kyouichirou**
**Osaka-shi**
**Osaka 554-0024 (JP)**
• **Yamaguchi, Takashi**
**Koka-shi**
**Shiga 528-0068 (JP)**
• **Kawakami, Shigeki**
**Koka-shi**
**Shiga 528-0068 (JP)**
• **Kimura, Michihiro**
**koka-shi**
**Shiga 528-0068 (JP)**

(74) Representative: **Boult Wade Tennant**
**Verulam Gardens**
**70 Gray's Inn Road**
**London WC1X 8BT (GB)**

(56) References cited:
DE-A1-102005 031 181     JP-A- 6 347 825
JP-A- 9 291 372          JP-A- 10 186 351
JP-A- 2000 012 621       JP-A- 2001 210 933
JP-A- 2002 105 662       JP-A- 2002 299 809
JP-A- 2004 006 580       JP-A- 2006 024 889
JP-A- 2006 032 639       JP-A- 2006 041 374
JP-A- 2006 190 960       JP-A- 2007 013 099
JP-A- 2008 078 384       JP-A- 2008 094 908
JP-A- 2008 308 519       JP-A- 2009 084 307
JP-A- 2009 088 454       JP-A- 2009 099 591
JP-B2- 2 919 976         US-A- 5 611 140
US-A1- 2002 023 342      US-B1- 6 375 060

## Description

Technical Field

The present invention relates to a connection method in which an electrical connection is established with an adhesive, a connection structure, and an electronic device, which are formed by the connection method.

Background Art

In recent years, there have been advances in a reduction in the size of connection terminals in components (for example, electronic components in liquid crystal productions) due to a trend toward miniaturization and higher functionality of electronic devices. Thus, in the field of electronics mounting, film adhesives are widely used as various anisotropic conductive adhesives capable of easily establishing connections between the terminals. For example, film adhesives are used for the joint between printed circuit boards, such as flexible printed circuit boards (FPCs) and rigid printed wiring (or circuit) boards (PWBs or PCBs), provided with electrodes, such as copper electrodes, for connection using adhesives and interconnection substrates, such as glass substrates, provided with connection electrodes, such as copper electrodes, and between printed circuit boards and electronic components, such as integrated circuit(IC) chips.

An anisotropic conductive adhesive is an adhesive containing electrically conductive particles dispersed in an insulating resin composition. The anisotropic conductive adhesive is interposed between connection members, heated, and pressurized to bond the connection members to each other. That is, for example, the heating and pressurization allow a resin in the adhesive to flow to seal a gap between an electrode for connection using an adhesive formed on a surface of a printed circuit board and a connection electrode formed on an interconnection substrate. Simultaneously, some of the electrically conductive particles are arranged between the connection electrode and the electrode for connection using an adhesive, thereby establishing an electrical connection. Here, each of the electrode for connection using an adhesive of the printed circuit board and the connection electrode of the interconnection substrate is generally subjected to gold plating in order to achieve prevention of oxidation and electrical conduction properties (for example, see PTL 1).

Technical Problem

However, gold plating layers are formed after nickel plating layers are formed on surfaces of the electrode for connection using an adhesive and the connection electrode, thus leading to a complex production process. As a result, the production cost when a flexible printed circuit board, an interconnection substrate, and so forth are connected to each other is disadvantageously increased.

Citation List

Patent Literature

PTL 1: Japanese Unexamined Patent Application Publication No. 10-79568

US 5611140 discloses a method for forming a bumped substrate by forming at least one electrically conductive polymer bump on a first set of bond pads of the substrate. Electrically conducted polymer bumps are then formed on a second set of the bond pads of the substrate. An organic protective layer is formed around the bond pads of a second substrate and the polymer bumps of the first substrate are contacted with the bond pads of the second substrate and connected thereto by an electrically conductive adhesive.

DE 10 2005 031181A discloses a circuit board having one set of contact surfaces which make a connection using a conductive glue and another set of contacts which may be soldered.

US 6375060 discloses a solder reflow treatment in a non-oxidizing atmosphere.

JP 2008 308519A discloses an adhesive for connecting electrodes containing an epoxy resin as a main component.

US 2002/0023342A discloses a method of manufacturing an electronic device including a first component mounted on one main surface of a wiring board by thermocompression bonding using an interposed adhesive resin and a second electronic component mounted on a different area by melting of soldering paste.

Summary of Invention

It is an object of the present invention to provide a connection method for achieving a simple production process and a connection structure using an adhesive at low cost. Solution to Problem

A connection method according to the invention is set out in claim 1. With respect to the adhesive, as described below, any of anisotropic conductive adhesives (ACAs) and non-conductive adhesives (NCAs) may be used. Treatment to form the organic film is generally referred to as preflux treatment (organic solderability preservation (OSP) treatment). Examples of the base material include base films for printed wiring boards and base members for electrodes of electronic components. Examples of the connection conductor include electrodes of other printed wiring boards, electrodes of electronic components, and connector electrodes. An example of treatment to remove or thin the organic film is treatment to bring the organic film into contact with an acidic solution or its vapor.

Examples of the invention provide the following advantages. Hitherto, an electrode for connection using an adhesive has been subjected to gold plating for prevention of oxidation. In contrast, a step (b1) of forming an organic film by OSP treatment leads to a simple production process, as compared with a step of forming a gold plating layer. Furthermore, disuse of expensive gold results in a reduction in material cost. According to the present invention, it is thus possible to produce the electrode structure for connection using an adhesive at low cost. Meanwhile, the hardness of the organic film formed by OSP treatment varies depending on its constituent material or an environment after the formation. For example, the increase of cross-linking portions by high-temperature treatment, such as solder reflow, or exposure to ultraviolet rays can result in extremely high hardness. In this case, if a non-conductive adhesive is used, a portion of the electrode for connection using an adhesive and a portion of the connection conductor are less likely to come into contact with each other by breaking the organic film in the connection step. If an anisotropic conductive adhesive containing electrically conductive particles is used, the electrically conductive particles are less likely to come into contact with, for example, the electrode by breaking the organic film in the connection step. Thus, defective conduction can occur between the electrode for connection using an adhesive and the connection conductor in the connection step.

In contrast, in the present inventions, the connection step (d1) is performed after treatment (c1) to remove or thin the organic film. So, in either case, the electrode and the connection conductor are surely conductive with each other directly or with electrically conductive particles. It is thus possible to inhibit the occurrence of defective conduction between the electrode, which is located on the base material, for connection using an adhesive and the connection conductor on a connection member. Ultimately, the organic film is removed or thinned. So, it is possible to ensure conduction between the electrode for connection using an adhesive and the connection conductor, regardless of the thickness of the organic film at the time of the OSP treatment. Note that after the organic film is removed, if the time that elapses before a connection is established with an adhesive is not so long, the oxidation of the electrode and the connection conductor can be inhibited.

The treatment (c1) to remove or thin the organic film can be performed by bringing the organic film into contact with a solution or its vapor containing, for example, an inorganic acid, such as hydrochloric acid, or an organic acid, such as carboxylic acid or sulfonic acid. Examples of a method for bringing the organic film into contact with such an acidic solution or its vapor include a method in which the organic film is immersed in the solution containing the acid, a method in which the organic film is sprayed with the solution containing the acid or its vapor, and a method in which the organic film is wiped with a cloth that contains the solution containing the acid. It is confirmed that the organic film is removed or thinned by the method.

The adhesive used is preferably an anisotropic conductive adhesive containing electrically conductive particles. The electrically conductive particles can break through the organic film to come easily into contact with the electrode for connection using an adhesive.

The adhesive preferably contains electrically conductive particles formed of needle-shaped metal powder particles or a metal powder having a form in which a plurality of metal particles are connected in the form of a chain. This enhances the function of the electrically conductive particles to break through the organic film in the production process, thus smoothly forming the connection structure using an adhesive. In this case, the use of electrically conductive particles having an aspect ratio of 5 or more increases the contact probability between the electrically conductive particles. It is thus possible to smoothly form the connection structure using an adhesive without increasing the blending quantity of the electrically conductive particles.

In the case where an anisotropic conductive adhesive is used, an adhesive having a film-like shape is preferably used, thereby leading to the easy handling of the anisotropic conductive adhesive. Furthermore, workability when the connection structure using an adhesive is formed by the heat and pressure treatment is improved. In this case, more preferably, major axes of the electrically conductive particles are oriented in the thickness direction of the adhesive having a film-like shape. This maintains the insulation between adjacent electrodes or adjacent conductors to prevent a short circuit with respect to the planar direction of the adhesive. Furthermore, each of many electrodes is connected to a corresponding one of the conductors in one operation with respect to the thickness direction of the adhesive, thereby resulting in a low resistance.

The base material provided with an electrode for connection using an adhesive also includes an electrode for connection using solder. In this case, after organic films are formed on both of the electrode for connection using solder and the electrode for connection using an adhesive, a solder reflow step is performed, and then the connection using an adhesive is established. This is because if the connection using an adhesive is first established, the constriction of the adhesive is loosened during the subsequent solder reflow, so that poor connection is more likely to occur. Meanwhile, the organic films can be thermally decomposed during the solder reflow.

Accordingly, the organic films have a higher decomposition temperature than the solder reflow temperature. So, the organic films remain assuredly even after the solder reflow. Subsequently, the treatment to remove or thin the organic films is performed to smoothly establish the connection using solder and the connection using an adhesive.

The solder reflow temperature is about 260°C. Thus, more preferably, the organic films have a decomposition temperature of 300°C or higher. Organic films having high decomposition temperatures are exemplified below. Each organic film contains an organic compound having a coordinating atom capable of forming a coordinate bond with a metal constituting the electrode for connection using an adhesive. Thus, the organic film forms a complex with the metal constituting the electrode for connection using an adhesive, thereby increasing the decomposition temperature. In particular, an organic compound having a plurality of coordinating atoms in one molecule thereof can form a bridged complex to increase the decomposition temperature, which is preferred.

Specifically, the organic film containing at least one organic compound selected from, for example, 2-phenylimidazoles, such as 2-phenyl-4-methyl-5-benzylimidazole, 2,4-diphenylimidazole, and 2,4-diphenyl-5-methylimidazole, and benzimidazoles, such as 5-methylbenzimidazole, 2-alkylbenzimidazole, 2-arylbenzimidazole, and 2-phenylbenzimidazole, is preferably used.

Examples of the base material of the present invention include various wiring members and substrates. Wiring members include various types of wiring, such as wiring boards, e.g., flexible printed circuit boards and rigid printed wiring boards, and cable wiring, e.g., coaxial cable wiring and flat cable wiring. In particular, flexible printed circuit boards are contained in many electronic devices, such as cellular phones, cameras, e.g., digital cameras and video cameras, portable audio players, portable DVD players, and portable notebook personal computers. Use of the present invention provides outstanding advantages.

In examples of the method, a base material including an electrode for connection using an adhesive and an electrode for connection using solder is used. After only the electrode for connection using solder is covered with an organic film formed by OSP treatment or a noble metal plating film (b2), the electrode for connection using solder is joined to a connection conductor using solder by solder reflow treatment in a non-oxidizing atmosphere (c2). Then the electrode for connection using an adhesive is bonded to a connection conductor with an adhesive mainly containing a thermosetting resin to establish electrical connection (d2). With respect to the adhesive, as described below, any of anisotropic conductive adhesives (ACAs) and non-conductive adhesives (NCAs) may be used.

These examples provide the following advantages. In examples of the present invention, an organic film formed by OSP treatment or a noble metal plating layer is not formed on the electrode for connection using an adhesive. After only the electrode for connection using solder is covered with an organic film formed by OSP treatment or a noble metal plating layer (b2), connection with solder (solder reflow treatment) is performed (c2). Then the connection step (d2) with the adhesive is performed, so that the electrode and the connection conductor are conductive with each other directly or with electrically conductive particles. It is thus possible to inhibit the occurrence of defective conduction between the electrode, which is located on the base material, for connection using an adhesive and the connection conductor on a connection member. In the case where the electrode for connection using solder is covered with the organic film formed by the OSP treatment, there is no need to form a gold plating layer as described above, thus reducing the production cost. Furthermore, even in the case where the electrode for connection using solder is covered with a noble metal plating layer, there is no need to form a gold plating layer on the electrode for connection using an adhesive, and OSP treatment is not performed, thus reducing the production cost.

Before the solder reflow step (c2), a detachable protective film may be formed on the electrode for connection using an adhesive. The protective film may be removed before a connection with the adhesive is established. Also in this case, the electrode and the connection conductor are conductive with each other directly or with electrically conductive particles. Furthermore, it is possible to suppress the formation of an oxide film on the electrode for connection using an adhesive, thereby surely inhibiting the occurrence of defective conduction between the electrode for connection using an adhesive and the connection conductor.

After the connection with solder is established, an oxide film on the electrode for connection using an adhesive may be removed before connection with the adhesive. This makes it possible to assuredly inhibit the occurrence of defective conduction between the electrode for connection using an adhesive and the connection conductor.

The connection with solder (solder reflow treatment) is preferably performed in a non-oxidizing atmosphere having an oxygen concentration of 1% or less. This inhibits the formation of an oxide film on a surface of the electrode for connection using an adhesive even if the surface of the electrode is exposed.

In further examples of the method, the connection using solder reflow treatement is established in such a manner that the increase in connection resistance between the electrode for connection using an adhesive and the connection conductor before and after the solder reflow treatment is within a predetermined range. With respect to the adhesive, as described below, any of anisotropic conductive adhesives (ACAs) and non-conductive adhesives (NCAs) may be used. Examples of the oxidation preventing film include noble metal plating layers, such as gold plating layers, and organic films. Examples of the base material include base films for printed wiring boards and base members for electrodes of electronic components. Examples of the connection conductor and the connection conductor using solder include electrodes of other printed wiring boards, electrodes of electronic components, and connector electrodes. The connection conductor and the connection conductor using solder may be arranged on the same or different members.

These examples provide the following advantages. It has been found that in the case where connection with an adhesive is first performed, followed by solder reflow treatment, the connection resistance is increased. The reason for this is that the solder reflow treatment causes a relaxation phenomenon of the adhesive, thereby reducing the constricting force of the adhesive. In the inventions described in Claims 8 to 12, a change in connection resistance before and after the solder reflow treatment is within the predetermined range. It is thus possible to inhibit the occurrence of defective conduction between the electrode, which is located on the base material, for connection using an adhesive and the connection conductor on a conduction member.

In particular, before the solder reflow, upon letting the connection resistance between the electrode for connection using an adhesive and the connection conductor be $R_1$, and upon letting the adhesion strength of the adhesive be $F_1$, and after the solder reflow, upon letting the connection resistance between the electrode for connection using an adhesive and the connection conductor be $R_2$, and upon letting the adhesion strength of the adhesive be $F_2$, in the case where the connection is established in such a manner that relational expressions (1) and (2) hold:

$$R_2 < 1.2 \times R_1 \qquad (1)$$

$$F_2 > 0.8 \times F_1 \qquad (2),$$

the connection reliability is further increased.

The inventors have found that a resin material having a glass transition temperature of 100°C or higher after curing is used as a resin composition for the adhesive, which is effective in satisfying the expressions.

A glass transition temperature indicates a temperature at which the rigidity and viscosity of the resin composition change rapidly. A lower glass transition temperature results in a reduction in the strength (constricting force) of an adhesive at a higher temperature. So, the use of a resin material having a glass transition temperature of 100°C or higher facilitates the establishment of a connection that satisfies relational expressions (1) and (2).

The formation of an organic film as the oxidation preventing film reduces the production cost. Hitherto, electrodes for connection using an adhesive have been subjected to gold plating for oxidation prevention. In contrast, the step of forming the organic film by preflux treatment (organic solderability preservation (OSP) treatment) simplifies the production process, as compared with a step of forming a gold plating layer. Furthermore, gold, which is expensive, is not used, reducing material cost. It is thus possible to establish the connection using the adhesive at low cost.

A connection structure may be formed by the connection method described above. An electronic device of the present invention is assembled by the connection method described above.

In particular, the following structure may be used as a connection structure between a first conductor on a first member and a second conductor on a second member. That is, a surface, excluding a conductive portion, of at least one of the first conductor and the second conductor is covered with an oxidation preventing film having a thickness of 0.05 μm or less.

The connection structure and the electronic device provide the simplification of the production process and a reduction in the amount of gold plating, thereby achieving a reduction in production cost.

Advantageous Effects of Invention

It is possible to achieve a simple production process and a reduction in production cost.

Brief Description of Drawings

[Fig. 1] Figure 1 is a schematic perspective view illustrating the structure of a mobile terminal serving as an electronic device according to an embodiment of the present invention.

[Fig. 2] Figure 2 is a cross-sectional view illustrating an exemplary structure of a connection part of the mobile terminal according to an embodiment.

[Fig. 3] Figure 3 is a perspective view illustrating an end portion of a wiring body before the formation of a connection structure using an adhesive according to an embodiment.

[Fig. 4] Figure 4 is a cross-sectional view illustrating connection structures using an adhesive according to a first example of a first embodiment, the connection structures being arranged between a flexible printed circuit board and a mother board.

[Fig. 5] Figure 5 is a cross-sectional view illustrating connection structures using an adhesive according to a second example of the first embodiment.

[Fig. 6] Figure 6 is an explanatory drawing illustrating the ratio of the major axis to the minor axis of electrically conductive particles.

[Figs. 7(a) to 7(d)] Figures 7(a) to 7(d) are cross-sectional views illustrating the procedure of a method of assembling an electronic component including a connection structure using an adhesive and a connection structure using solder according to the first embodiment.

[Fig. 8] Figure 8 is a cross-sectional view illustrating a connection structure using an adhesive and a connection structure using solder according to a first example of a second embodiment, the connection structure using an adhesive being arranged between a flexible printed circuit board and a mother board, and the connection structure using solder being arranged between an electronic component and the mother board.

[Fig. 9] Figure 9 is a cross-sectional view illustrating a connection structure using an adhesive and a connection structure using solder according to a second example of the second embodiment.

[Figs. 10(a) to 10(d)] Figures 10(a) to 10(d) are cross-sectional views illustrating the procedure of a method of assembling an electronic component including a connection structure using an adhesive and a connection structure using solder according to the first example of the second embodiment.

[Figs. 11(a) to 11(d)] Figures 11(a) to 11(d) are cross-sectional views illustrating the procedure of a method of assembling an electronic component including a connection structure using an adhesive and a connection structure using solder according to the second example of the second embodiment.

[Fig. 12] Figure 12 is a cross-sectional view illustrating a connection structure using an adhesive and a connection structure using solder according to a first example of a third embodiment, the connection structure using an adhesive being arranged between a flexible printed circuit board and a mother board, and the connection structure using solder being arranged between an electronic component and the mother board.

[Fig. 13] Figure 13 is a cross-sectional view illustrating a connection structure using an adhesive and a connection structure using solder according to a second example of the third embodiment.

[Figs. 14(a) to 14(c)] Figures 14(a) to 14(c) are cross-sectional views illustrating the procedure of a method of assembling an electronic component including a connection structure using an adhesive and a connection structure using solder according to the third embodiment.

Description of Embodiments

- Electronic device -

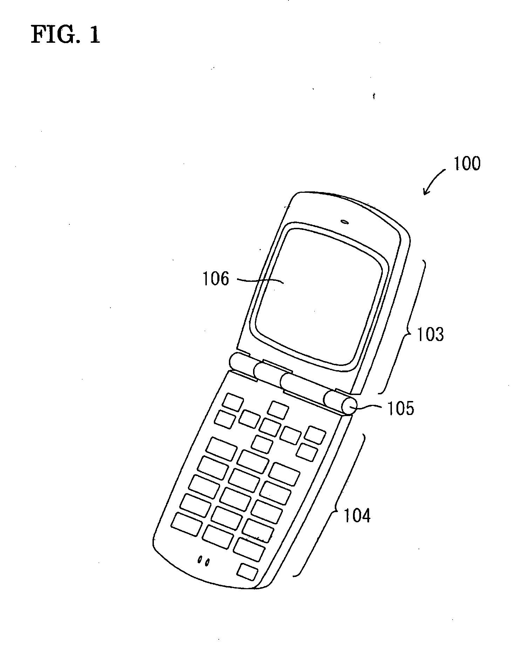

Figure 1 is a schematic perspective view illustrating the structure of a mobile terminal 100 serving as an electronic device according to an embodiment of the present invention.

The mobile terminal 100 includes a display unit 103 configured to display various pieces of information, an input unit 104, and a hinge part 105. The display unit 103 includes a display device 106 provided with a liquid crystal display panel, a speaker, and other components. The input unit 104 includes input keys and a microphone. The hinge part 105 rotatably connects the input unit 104 to the display unit 103.

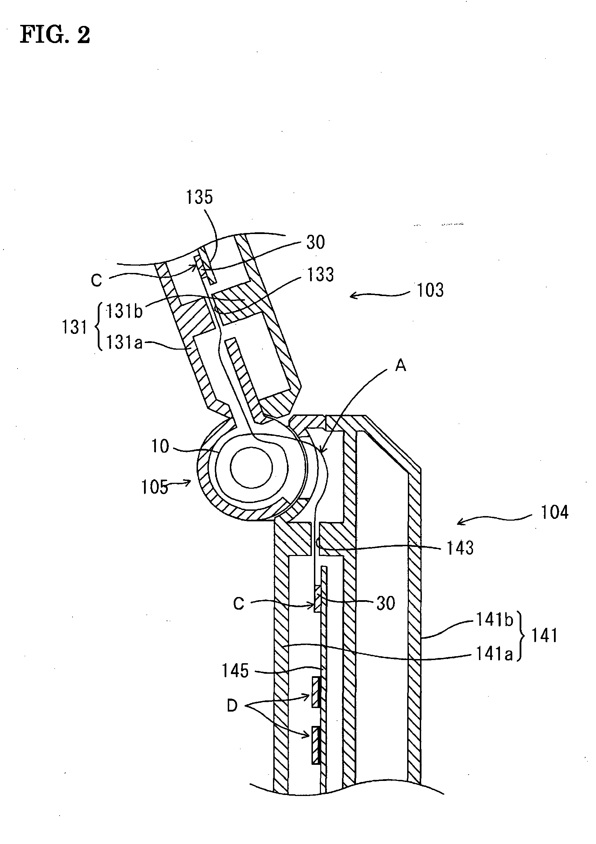

Figure 2 illustrates a cross section of the structure of a connection part of the mobile terminal 100 through the hinge part 105 according to an embodiment.

The display unit 103 includes a display section case 131 and a display section substrate 135, which serve as main members. The display section substrate 135 includes, for example, a circuit configured to send a display signal to the display device 106. The display section case 131 includes a first case 131a and a second case 131b that are connected to each other. Furthermore, a through hole 133 is arranged between the first case 131a and the second case 131b.

The input unit 104 includes an input section case 141 and an input key board 145, which serve as main members. The input key board 145 includes, for example, a circuit configured to control a signal sent from an input key. The input section case 141 includes a first case 141a and a second case 141b that are connected to each other. Furthermore, a through hole 143 is arranged between the first case 141a and the second case 141b.

In addition, a wiring body A is arranged to connect the input key board 145 to the display section substrate 135 through the hinge part 105. The wiring body A includes an FPC 10 and a connection structure C using an adhesive, the connection structure C being arranged on both ends of the FPC 10 through an anisotropic conductive adhesive 30.

The input key board 145 includes a connection structure D using solder in which electronic components are joined using solder. Similarly, the display section substrate 135 includes a connection structure D using solder in which electronic components are joined using solder (not illustrated).

-Electrode Structure and Wiring Body-

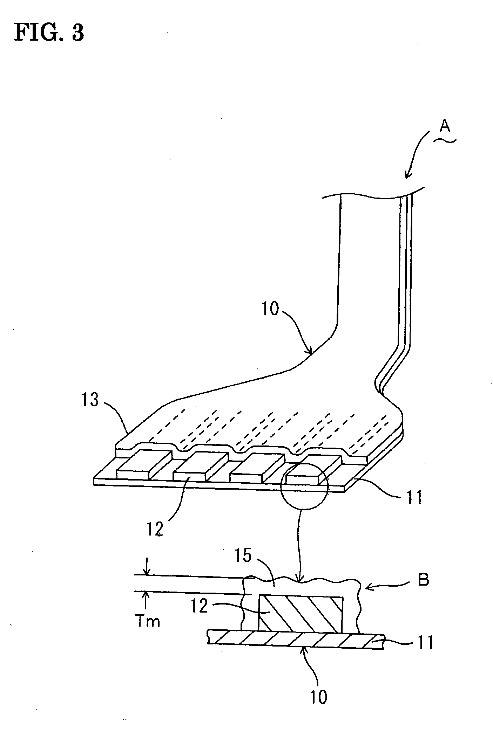

Figure 3 is a perspective view illustrating an end portion of the wiring body A before the formation of the connection structure C using an adhesive according to this embodiment. The wiring body A includes the FPC 10 (base material) and an electrode structure B arranged at the end portion.

The FPC 10 typically has a structure including a base film 11 provided with circuit layers (see broken lines) and a coverlay 13 that covers the base film 11. End portions of the circuit layers are formed of electrodes 12 for connection using an adhesive, the electrodes 12 being configured to be electrically connected to connection conductors.

Examples of a material for the base film 11 of the FPC 10 include polyimide resins, polyester resins, and glass epoxy resins. The coverlay 13 is typically composed of a material the same as a material constituting the base film. In addition, epoxy resins, acrylic resins, polyimide resins, polyurethane resins, and so forth may be used.

The circuit layers of the FPC 10 are formed by laminating metallic foil, such as copper foil, on the base film 11 and subjecting the metallic foil to lithographic exposure and etching in the usual manner. The circuit layers are typically composed of copper or a copper alloy. With respect to the circuit layers, the electrodes 12 for connection using an adhesive are exposed. Typically, gold plating layers serving as oxidation preventing films for the electrodes 12 for connection using an adhesive are provided.

In contrast, for the electrode structure B according to this embodiment, a gold plating layer and another noble metal plating layer (e.g., a silver plating layer, platinum plating layer, or a palladium plating layer) are not arranged on the electrodes 12 for connection using an adhesive. Each of the electrodes 12 for connection using an adhesive is covered with an organic film 15 serving as an oxidation preventing film in place of the noble metal plating layer.

The organic films 15 are formed by aqueous preflux treatment (organic solderability preservation (OSP) treatment).

Examples of a method for performing the OSP treatment include a spray method, a shower method, and a dipping method. Subsequently, washing with water and drying may be performed. In this case, the temperature of an aqueous preflux is preferably in the range of 25°C to 40°C. The time of contact between the aqueous preflux and the electrodes 12 for connection using an adhesive is preferably in the range of 30 to 60 seconds.

Typically, the aqueous preflux is an acidic aqueous solution containing an azole compound. Examples of the azole compound include azole compounds, such as imidazole, 2-undecylimidazole, 2-phenylimidazole, 2,4-diphenylimidazole, triazole, aminotriazole, pyrazole, benzothiazole, 2-mercaptobenzothiazole, benzimidazole, 2-butylbenzimidazole, 2-phenylethylbenzimidazole, 2-naphthylbenzimidazole, 5-nitro-2-nonylbenzimidazole, 5-chloro-2-nonylbenzimidazole, 2-aminobenzimidazole, benzotriazole, hydroxybenzotriazole, and carboxybenzotriazole.

In this embodiment, each of the organic films 15 has a higher decomposition temperature than the solder reflow temperature at the time of the formation of the connection structure D using solder. Typically, a reflow temperature for lead-free solder is about 260°C. Thus, a resin with a decomposition temperature of 260°C or higher and preferably 300°C or higher is used for the organic films 15.

Among the foregoing azole compounds, examples of an organic compound that satisfies the requirement include 2-phenylimidazoles, such as 2-phenyl-4-methyl-5-benzylimidazole, 2,4-diphenylimidazole, and 2,4-diphenyl-5-methylimidazole; and benzimidazoles, such as 5-methylbenzimidazole, 2-alkylbenzimidazole, 2-arylbenzimidazole, and 2-phenylbenzimidazole.

However, in the case where a solder reflow step is not performed before a connection step with an adhesive, the organic films 15 need not have a higher decomposition temperature than the solder reflow temperature. So, the organic compound is not limited to the foregoing compounds.

According to the electrode structure B and the wiring body A according to this embodiment, the following effects can be provided.

Hitherto, a noble metal plating layer, such as a gold plating layer, serving as an oxidation preventing film has been formed on an electrode for connection using an adhesive, in which a connection will be established using an anisotropic conductive adhesive (ACA) or a non-conductive adhesive (NCA).

In contrast, in this embodiment, the electrodes 12 for connection using an adhesive are covered with the organic films 15, which are OSP films as an alternative to the noble metal plating layers. The organic films 15 are formed by employing, for example, a spray method, a shower method, or a dipping method and then performing only washing with water and drying. Thus, a process of forming an oxidation preventing film is simplified, as compared with the case of the formation of a noble metal plating layer, such as a gold plating layer. Furthermore, the material cost is reduced, as compared with the case of using a noble metal, such as gold. Moreover, it is possible to improve the connection strength (shear strength) between connection electrodes and the electrodes 12 for connection using an adhesive, as compared with the case of the formation of the gold plating layer.

In general, a member to be mounted using solder is often arranged on a wiring body, such as the FPC 10. In that case, when the wiring body is passed through a solder reflow furnace after the formation of the organic films 15, the organic films 15 can be thermally decomposed.

Here, in this embodiment, the organic films 15 formed on the electrodes 12 for connection using an adhesive have a higher decomposition temperature than the solder reflow temperature. Thus, even when a substrate on which the electrodes 12 for connection using an adhesive are formed is passed through the solder reflow furnace, the organic films 15 remain assuredly without being thermally decomposed.

A base material on which the electrode structure B is formed is not limited to a flexible printed circuit board (FPC) and may be another type of wiring board, such as a rigid printed wiring board (PWB), cable wiring, an electronic component, a connector, or the like.

- Connection Structure Using Adhesive According to First Example of First Embodiment -

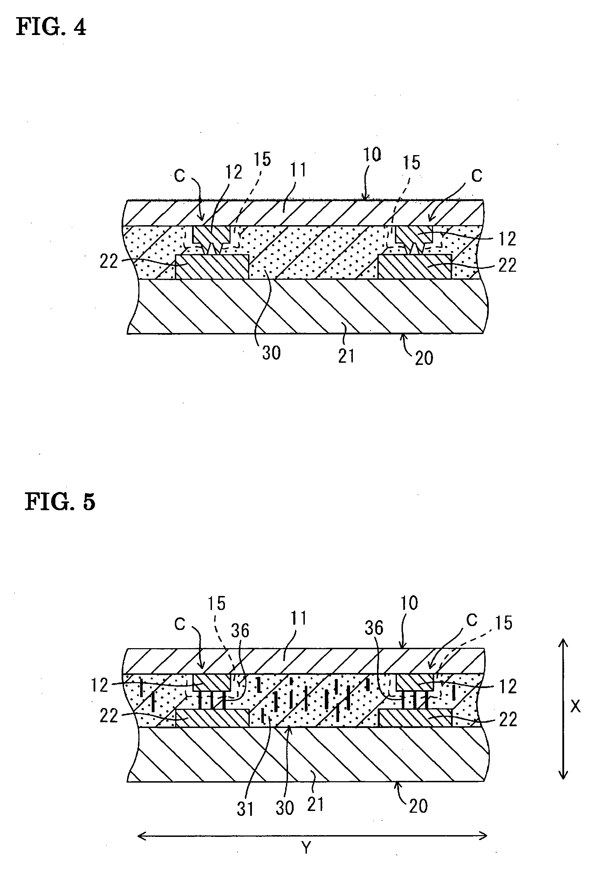

Figure 4 is a cross-sectional view illustrating a connection structure C using an adhesive according to a first example of a first embodiment, the connection structure C being formed between the flexible printed circuit board (FPC) 10 and a mother board 20. The connection structure C using an adhesive is formed with a non-conductive adhesive (NCA).

The mother board 20 includes a rigid printed wiring board 21 and electrodes 22 for connection using an adhesive, the electrodes 22 being arranged on the rigid printed wiring board 21. The mother board 20 is a rigid printed wiring board (PWB) corresponding to the display section substrate 135 or the input key board 145 illustrated in Fig. 2. The FPC 10 is mounted on the mother board 20 in such a manner that the electrodes 12 for connection using an adhesive are directed below the base film 11.

The electrodes 22 for connection using an adhesive on the mother board 20 are formed by laminating metallic foil, such as copper foil, on the rigid printed wiring board 21 and subjecting the metallic foil to lithographic exposure and etching in the usual manner.

Both the electrodes 12 and 22 for connection using an adhesive are tightly contacted by a constricting force of the adhesive 30, which is an NCA, and are conductive with each other.

The adhesive 30 contains a thermosetting resin, which is a main component, a curing agent, and various types of fillers. Examples of the thermosetting resin include epoxy resins, phenol resins, polyurethane resins, unsaturated polyester resins, urea-formaldehyde resins, and polyimide resins. Among these resins, in particular, the use of an epoxy resin as the thermosetting resin makes it possible to improve film-forming performance, heat resistance, and adhesion strength. The adhesive 30 may contain at least one resin, serving as a main component, selected from the foregoing thermosetting resins.

Examples of the epoxy resin that can be used include, but are not particularly limited to, bisphenol A-, F-, S-, and AD-type epoxy resins, copolymer-type epoxy resins of bisphenol A-types and bisphenol F-types, naphthalene-type epoxy resins, novolac-type epoxy resins, biphenyl-type epoxy resins, and dicyclopentadiene-type epoxy resins. Furthermore, phenoxy resins, which are high molecular weight epoxy resins, may also be used.

Although the electrodes 12 and 22 for connection using an adhesive are covered with the organic films configured to prevent oxidation, the organic films are removed after a solder reflow step before the formation of the connection structures C using an adhesive.

However, the organic films 15 may be left on the surfaces of one of the electrodes (for example, the electrodes 12 for connection using an adhesive) (see dotted lines in Fig. 4). This is because, for example, in the case where the FPC 10 is not subjected to solder reflow processing, i.e., in the case where the organic film 15 is not hardened, the organic film 15 need not be removed.

In place of the removal of the organic films, the thickness of the organic films is reduced to, about 0.05 $\mu$m or less.

Examples of a method for bringing the organic films into contact with an acidic solution or its vapor in order to remove the organic films or thin the organic films include a method in which the organic films are immersed in the solution, a method in which the organic films are sprayed with the acidic solution or its vapor, and a method in which the organic films are wiped with a cloth containing the acidic solution. It is confirmed that the organic films are removed or thinned by the method.

Before a lapse of an allowable suspension time of about three days after the removal of the organic films, a connection step can be performed using the adhesive with substantially no oxide film formed on the surface of each of the electrodes 12 and 22 for connection using an adhesive. In the case where the organic films are not completely removed but are left while having a small thickness, the allowable suspension time can be extended. Also in the case where storage is performed at a low temperature, a low humidity, or in a non-oxidizing atmosphere, the allowable suspension time can be extended.

To establish a connection, the adhesive is melted by heating while the adhesive is pressurized toward the mother board 20 at a predetermined pressure via the FPC 10 (hereinafter, referred to as "heat and pressure treatment"). Thereby, the thermosetting resin in the adhesive 30 is cured, so that the electrodes 12 for connection using an adhesive on the FPC 10 and the electrodes 22 for connection using an adhesive on the mother board 20 are tightly contacted by a constricting force due to its contraction and are conductive with each other. In this case, a portion (electrically conductive portion) of each of the electrodes 12 for connection using an adhesive is not covered with the organic films 15, so that electrical conduction is established.

In this embodiment, the electrodes 12 for connection using an adhesive on the FPC 10 are processed by etching so as to have rough surfaces. Note that machining, such as embossing, may be employed in addition to the etching.

In the case where the electrodes 12 and 22 for connection using an adhesive are covered with the organic films 15, when a protruding portion is arranged on a surface of at least one of the electrodes, the protruding portion breaks through the organic films 15. Hence, the electrodes 12 and 22 for connection using an adhesive are assuredly contacted to each other. A bump may be arranged between the electrodes 12 and 22 for connection using an adhesive.

According to the first example, the following effects are provided in addition to the effects of the electrode structure.

For example, in the case where at least one of the FPC 10 and the mother board 20 is subjected to a solder reflow step or is allowed to stand for prolonged periods of time to be exposed to ultraviolet rays, the corresponding organic film 15 can be hardened. In this case, the conduction between the electrodes 12 and 22 for connection using an adhesive can be precluded by the organic film to increase the electrical connection resistance. In particular, if heating is performed in the solder reflow furnace, the organic film is liable to be hardened.

The hardness of the organic film formed by the OSP treatment varies depending on its constituent material. In some cases, a very hard organic film must be used.

Thus, the protruding portion of each electrode 12 for connection using an adhesive is less likely to break through the hardened organic film, leading to an increase in connection resistance.

In contrast, in this embodiment, the connection step is performed after the organic films on the electrodes 12 and 22 for connection using an adhesive are removed or thinned. So, the protruding portions of the electrodes 12 for connection using an adhesive come easily into contact with the electrodes 22 for connection using an adhesive. In the case where the organic film on one of the electrodes is not subjected to the solder reflow step, the protruding portions of the electrodes 12 for connection using an adhesive break easily through the organic films. So, there is no need to remove or thin the organic film.

Accordingly, it is possible to inhibit the occurrence of defective conduction (e.g., an increase in connection resistance) between the electrodes 12 for connection using an adhesive and the electrodes 22 (connection conductors) for connection using an adhesive.

In the case where the organic film to be subjected to the solder reflow step is not removed or thinned, in order to surely establish conduction between conductors, it is necessary to perform control as described below: for example, the average thickness of the organic film is set to be in an appropriate range (for example, 0.05 $\mu$m to 0.5 $\mu$m), and the area proportion of a region having a small thickness is set to be high (for example, the area of a region having a thickness of 0.1 $\mu$m or less is set to 30% or more of the area of the entire organic film).

In contrast, in this embodiment, the organic film is removed or thinned. So, no failure occurs even if the thickness of the organic film at the time of the OSP treatment is, for example, 0.5 $\mu$m or more.

- Connection Structure Using Adhesive According to Second Example of First Embodiment -

Figure 5 is a cross-sectional view illustrating connection structures C using an adhesive according to a second example of the first embodiment. In each of the connection structures C using an adhesive, the adhesive 30, which is an anisotropic conductive adhesive (ACA), is used. That is, the adhesive 30 used in this example contains electrically conductive particles 36 in a resin composition 31 mainly composed of a thermosetting resin.

Also in this example, the mother board 20 includes the rigid printed wiring board 21 and the electrodes 22 for connection using an adhesive, the electrodes 22 being arranged on the rigid printed wiring board 21. Also in this example, surfaces of the electrodes 12 for connection using an adhesive and surfaces the electrodes 22 for connection using an adhesive are covered with the organic films 15, excluding electrically conductive portions.

The electrodes 12 and 22 for connection using an adhesive are electrically connected to each other through the electrically conductive particles 36. The electrically conductive particles 36 are formed of needle-shaped metal powder particles or a metal powder having a form in which many fine metal particles are connected in the form of a straight chain.

Similarly to the first example of the first embodiment, also in this example, the electrodes 12 and 22 for connection using an adhesive may be directly contacted to each other.

Also in this example, although the electrodes 12 and 22 for connection using an adhesive are covered with the organic films, the organic films are removed or thinned after a solder reflow step before the formation of the connection structures C using an adhesive.

In the case where the FPC 10 is not subjected to the solder reflow step, the organic films 15 indicated by dotted lines in the figure need not be removed or thinned.

A specific method of the treatment to remove or thin the organic films is the same as that described in the first example.

When a connection is established, the thermosetting resin in the adhesive 30 is cured by the above-described heat and pressure treatment. The electrodes 12 and 22 for connection using an adhesive are connected to each other through the electrically conductive particles 36 by a constricting force due to its contraction.

In this example, the electrically conductive particles 36 each having a needle shape or having a form in which many fine metal particles are connected in the form of a straight chain are contained in the resin composition 31 from the beginning.

However, electrically conductive particles formed of fine metal particles dispersed in the resin composition 31 in a random manner may be used. This is because also in that case, the heat and pressure treatment causes the fine metal particles to have a form in which many fine metal particles are connected between the electrodes 12 and 22 for connection using an adhesive.

As the anisotropic conductive adhesive used in the second example of the first embodiment, a commonly used adhesive, i.e., an adhesive containing the electrically conductive particles 36 dispersed in a resin composition mainly composed of an insulating thermosetting resin, such as an epoxy resin, may be used. For example, an adhesive in which electrically conductive powder particles of, for example, nickel, copper, silver, gold, or graphite, are dispersed in an epoxy resin is exemplified. Here, examples of the thermosetting resin include epoxy resins, phenol resins, polyurethane resins, unsaturated polyester resins, urea-formaldehyde resins, and polyimide resins. Among these resins, in particular, the use of an epoxy resin as the thermosetting resin makes it possible to improve the film-forming performance, heat resistance, and adhesion strength of the anisotropic conductive adhesive. The anisotropic conductive adhesive may contain at least one resin, serving as a main component, selected from the foregoing thermosetting resins.

Examples of the epoxy resin that can be used include, but are not particularly limited to, bisphenol A-, F-, S-, and AD-type epoxy resins, copolymer-type epoxy resins from bisphenol A-types and bisphenol F-types, naphthalene-type epoxy resins, novolac-type epoxy resins, biphenyl-type epoxy resins, and dicyclopentadiene-type epoxy resins. Furthermore, phenoxy resins, which are high molecular weight epoxy resins, may also be used.

The molecular weight of the epoxy resin may be appropriately selected in view of the performance of the anisotropic conductive adhesive required. In the case where an epoxy resin with a higher molecular weight is used, the epoxy resin has high film-forming performance and a high melt viscosity at a connection temperature, thereby providing the effect in which a connection can be established without disturbing the orientation of the electrically conductive particles to be hereinafter described. Meanwhile, use of an epoxy resin with a low molecular weight provides the effect of increasing the crosslink density to improve the heat resistance. Furthermore, the effect of causing a rapid reaction with the foregoing curing agent during heating to enhance the adhesion performance is provided. Thus, the use of a combination of a high-molecular-weight epoxy resin having a molecular weight of 15,000 or more and a low-molecular-weight epoxy resin having a molecular weight of 2000 or less is preferred because of a good performance balance. The blending quantities of the high-molecular-weight epoxy resin and the low-molecular-weight epoxy resin may be appropriately selected. The term "molecular weight" used here indicates a weight-average molecular weight in terms of polystyrene determined by gel permeation chromatography (GPC) using a developing solvent consisting of tetrahydrofuran.

Furthermore, an adhesive containing a latent hardener may be used as the adhesive 30 used in this example and the first example of the first embodiment. Although the latent hardener has excellent storage stability at a low temperature and is much less likely to cause a curing reaction at room temperature, the latent hardener rapidly causes the curing reaction by heat, light, or the like. Examples of the latent hardener include hardeners of amine types, such as imidazole types, hydrazide type, boron trifluoride-amine complexes, amine imides, polyamine types, tertiary amines, and alkyl urea types, dicyandiamide types, acid anhydride types, phenol types, and modified materials thereof. These may be used separately or in combination as a mixture of two or more.

Among these latent hardeners, imidazole type latent hardeners are preferably used from the viewpoint of excellent storage stability at low temperatures and fast curing. Known imidazole type latent hardeners may be used as the imidazole type latent hardeners. More specifically, adducts of imidazole compounds and epoxy resins are exemplified. Examples of imidazole compounds include imidazole, 2-methylimidazole, 2-ethylimidazole, 2- propylimidazole, 2-dodecylimidazole, 2-phenylimidazole, 2-phenyl-4-methylimidazole, and 4-methylimidazole.

In particular, microencapsulated latent hardeners each formed by coating a corresponding one of the foregoing latent hardeners with a high molecular material of, for example, polyurethane type or polyester type, or with a metal thin film composed of nickel or copper and an inorganic substance, such as calcium silicate, are preferred because they are able to successfully strike a balance between long-life nature and fast curing, which are a trade-off relationship. Thus, microencapsulated imidazole type latent hardeners are particularly preferred.

In the second example of the first embodiment, the removal or thinning of the organic films after the solder reflow step provides the same effects as in the first example of the first embodiment. However, in this example, the electrodes 12 and 22 for connection using an adhesive are conductive with each other through the electrically conductive particles 36.

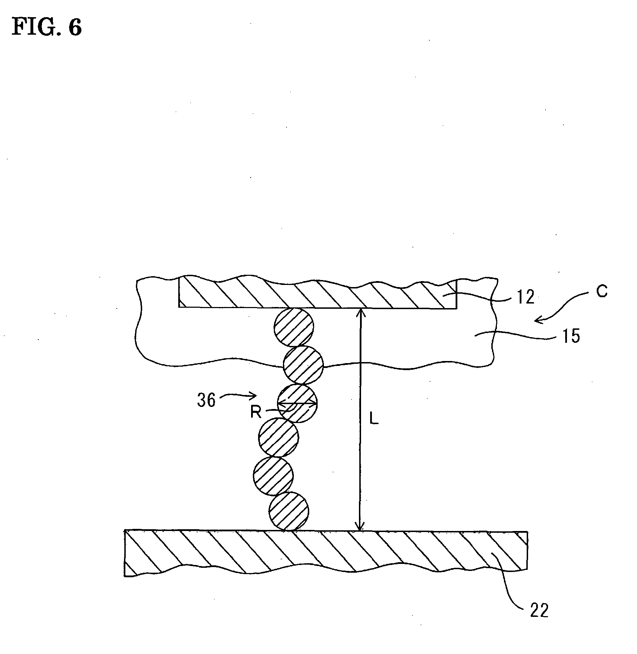

In the case where the adhesive having the form illustrated in Fig. 6 is used as the anisotropic conductive adhesive, in particular, the following configuration may be used.

Specifically, the anisotropic conductive adhesive containing, for example, the foregoing insulating thermosetting resin, such as an epoxy resin, serving as a main component, and the electrically conductive particles 36 dispersed therein may be used, the electrically conductive particles 36 being formed of a high-aspect-ratio metal powder having a needle shape or having a form in which many fine metal particles (fine metal particles such as spherical metal particles or spherical resin particles plated with a metal) are connected in the form of a straight chain. The term "aspect ratio" used herein indicates the ratio of the major axis L (the length of the electrically conductive particles 36) to the minor axis R of each of electrically conductive particles 36 (the length of the cross section of each of the electrically conductive particles 36) as shown in Fig. 6.

Use of the electrically conductive particles 36 maintains the insulation between adjacent electrodes to prevent a short circuit with respect to the planar direction (a direction that is directed perpendicular to the thickness direction X and indicated by an arrow Y illustrated in Fig. 5) of the anisotropic conductive adhesive, and electrically connects each of many electrodes 22 for connection using an adhesive to a corresponding one of the electrodes 12 for connection using an adhesive in one operation with respect to the thickness direction X, thereby resulting in a low resistance.

The anisotropic conductive adhesive in which the major axes L of the electrically conductive particles 36 are oriented in the thickness direction X of the film-like anisotropic conductive adhesive by passing the anisotropic conductive adhesive through a magnetic field applied in the thickness direction X at the time of the formation of the film-like anisotropic conductive adhesive, is preferably used. This orientation further improves the foregoing effect of maintaining the insulation between adjacent electrodes to prevent a short circuit and of electrically connecting each of many electrodes 22 for connection using an adhesive to a corresponding one of the electrodes 12 for connection using an adhesive in one operation.

Preferably, the metal powder used in the present invention partially contains a ferromagnetic substance. The metal powder is preferably composed of any one of ferromagnetic elemental metals, two or more component ferromagnetic alloys, alloys of ferromagnetic metals and the other metals, and complexes containing ferromagnetic metals. This is because the use of the ferromagnetic metal permits the metal particles to be oriented by the use of a magnetic field owing to the magnetism of the metal itself. Examples thereof include nickel, iron, cobalt, and two or more component alloys containing thereof.

Each of the electrically conductive particles 36 preferably has an aspect ratio of 5 or more. The use of the electrically conductive particles 36 increases the contact probability between the electrically conductive particles 36 and the electrodes 12 and 22 for connection using an adhesive when the anisotropic conductive adhesive is used as the adhesive 30. It is thus possible to electrically connect the electrodes 12 and 22 for connection using an adhesive to each other without increasing the blending quantity of the electrically conductive particles 36.

The aspect ratio of each of the electrically conductive particles 36 is directly measured by, for example, observation with a charge-coupled device (CCD) microscope. For the case where each of the electrically conductive particles 36 has a noncircular cross section, the maximum length of the cross section is defined as the minor axis, and then the aspect ratio is determined. Each of the electrically conductive particles 36 need not necessarily have a straight shape. Even if they are slightly curved or branched, they can be used without problems. In this case, the maximum length of each of the electrically conductive particles 36 is defined as the major axis, and then the aspect ratio is determined.

- Connection Method According to First Embodiment -

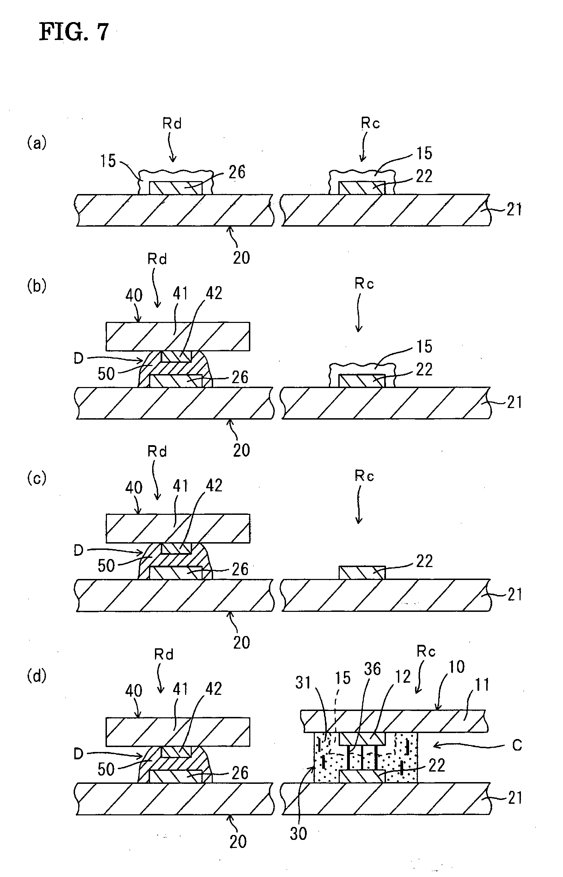

Figures 7(a) to 7(d) are cross-sectional views illustrating the procedure of a connection method for forming a connection structure C using an adhesive and a connection structure D using solder according to the first embodiment.

In a step illustrated in Fig. 7(a), the mother board 20 (common base material) including a region Rc for connection using an adhesive and a region Rd for connection using solder is prepared. In the mother board 20, the electrode 22 for connection using an adhesive is provided in the region Rc for connection using an adhesive, and an electrode 26 for connection using solder is provided in the region Rd for connection using solder.

Next, the organic films 15 are formed so as to cover the electrodes 22 for connection using an adhesive and electrodes 26 for connection using solder. In this embodiment, the organic films 15 have a higher decomposition temperature than the solder reflow temperature.

Although not illustrated in Fig. 7(a), at this point, a protective film configured to cover the organic films 15 may be formed only in the region Rc for connection using an adhesive. Specifically, the organic films 15 are covered with, for example, an adhesive tape. A protective film other than the adhesive tape may be used.

Next, in a step illustrated in Fig. 7(b), an electronic component 40 having a chip-side electrode 42 located in a portion of a chip 41 is arranged in the region Rd for connection using solder. At this point, the chip-side electrode 42 is aligned with the electrode 26 for connection using solder, and lead-free solder is provided between the electrodes 26 and 42. Then the mother board 20 and the electronic component 40 are placed in a solder reflow furnace having a peak temperature of about 260°C to reflow the solder. Thus, the electrodes 26 and 42 are joined to each other through a solder layer 50 to electrically connect the electrodes 26 and 42 to each other.

Thereby, the connection structure D using solder is formed in the region Rd for connection using solder.

In a step illustrated in Fig. 7(c), the foregoing treatment to remove the organic films 15 is performed. To remove the organic films 15, the organic films 15 are brought into contact with an acidic solution or its vapor. Specifically, for example, the mother board 20 and the electronic component 40 are immersed in an acidic solution having a temperature of 30°C for about 1 minute. Alternatively, the organic films 15 are sprayed with an acidic solution or its vapor. In the latter method, the mother board 20 and the electronic component 40 need not be immersed in the acidic solution, thus suppressing the effect on other components.

Before a lapse of about 3 days after the step illustrated in Fig. 7(c), in a step illustrated in Fig. 7(d), the electrode 22 for connection using an adhesive is bonded to the electrode 12, which is located on the FPC 10, for connection using an adhesive, with the adhesive 30 to establish electrical connection. A procedure for forming the connection structure C using an adhesive is the same as that described in the foregoing second example of the connection structure using an adhesive (see Fig. 5).

Before the step illustrated in Fig. 7(d), the organic film 15 that covers the electrode 12, which is located on the FPC 10, for connection using an adhesive is removed or thinned.

However, in the case where the FPC 10 is not subjected to the solder reflow step, the organic film 15 need not be subjected to removal or thinning treatment.

By performing treatment to remove or thin the organic film 15, advantageously, there is little need to control the average thickness of the organic film 15 or the area proportion of a region having a small thickness at the time of the OSP treatment.

In the case where a protective film (e.g., an adhesive material) configured to cover the organic film 15 is formed in the step illustrated in Fig. 7 (a), the protective film is removed before the bonding with the adhesive 30.

Thereby, the connection structure C using an adhesive is formed in the region Rc for connection using an adhesive.

As described above, the adhesive 30 (anisotropic conductive adhesive) containing the electrically conductive particles 36 is mainly composed of a thermosetting resin. Thus, when the anisotropic conductive adhesive is heated, the anisotropic conductive adhesive is temporarily softened. When the heating is continued, the anisotropic conductive adhesive is cured. After a predetermined curing time of the anisotropic conductive adhesive, a pressurized state and a state in which the curing temperature of the anisotropic conductive adhesive is maintained are released, and then cooling is started. Thereby, the electrodes 12 and 22 for connection using an adhesive are connected to each other through the electrically conductive particles 36 in the adhesive 30 to mount the FPC 10 on the mother board 20.

Figures 7(a) to 7(d) illustrate an example of the formation of the connection structure C using an adhesive and the connection structure D using solder on the mother board 20 serving as a PWB.

Alternatively, the FPC 10 may be used as a common base material, and the connection structure C using an adhesive and the connection structure D using solder may be formed on the FPC 10. In that case, the mother board 20 illustrated in Figs. 7(a) to 7(d) is replaced with the FPC 10, and the organic film 15 is formed on the electrode 12 for connection using an adhesive. The procedure is the same as that described above.

Note that there are a single-sided circuit structure and a double-sided circuit structure in FPCs. For the FPC having the double-sided circuit structure, the FPC is passed through the solder reflow furnace twice.

In the connection method according to this embodiment, the following effects are provided in addition to the effects of the electrode structure B and the connection structure C using an adhesive.

Usually, in the case where a connection using solder and a connection using an adhesive are established on the same substrate, after the organic films 15 are formed on the electrode 26 for connection using solder and the electrode 22 for connection using an adhesive, the connection using solder is first established, and then the connection using an adhesive is established. This is because if the connection using an adhesive is first established, the constriction of the adhesive is loosened during the subsequent solder reflow, so that poor connection is more likely to occur. Meanwhile, the organic films can be thermally decomposed during the solder reflow process.

In the connection method according to this embodiment, in the step illustrated in Fig. 7(a), the organic films 15 formed on the electrode 22 for connection using an adhesive have a higher decomposition temperature than the solder reflow temperature. Thus, also in the step illustrated in Fig. 7(b), the organic films 15 remain assuredly without being thermally decomposed.

Note that the formation of a protective film on the organic films 15 permits the organic film 15 to remain more assuredly. It is thus possible to more assuredly form the connection structure D using solder and the connection structure C using an adhesive.

With respect to the organic film 15 covering the electrode 26 for connection using solder, although the organic film 15 has a higher decomposition temperature than the solder reflow temperature, the organic film 15 reacts with, for example, flux contained in the lead-free solder to dissolve into the solder layer 50. Thus, the connection structure D using solder is formed without any problem.

Gold plating need not necessarily be performed on the electrode 26 for connection using solder. However, in order to prevent tarnishing and so forth, gold plating is generally performed.

In this embodiment, there is no need to perform gold plating on any electrode of the mother board 20. As described above, the organic film 15 reacts with the flux to dissolve into the solder layer 50. Thus, the organic film 15 may be formed on the electrode 26 for connection using solder by the OSP treatment as an alternative to the gold plating. It is therefore possible to significantly enhance the effect of reducing the production cost described above.

Furthermore, the formation of the organic film 15 serving as an oxidation preventing film on the electrode 26 for connection using solder results in improvement in the connection strength (shear strength) between the electrodes 26 and 42.

Meanwhile, in the case where the connection structure C using an adhesive is formed after the solder reflow step, the connection resistance between the electrodes 12 and 22, which are electrically connected to each other, for connection using an adhesive can be increased, as compared with the case where it is not passed through the solder reflow furnace. This is presumably because the organic film 15 is altered (e.g., hardened) by heating in the solder reflow furnace, so that the electrically conductive particles 36 are less likely to break through the organic film 15.

Thus, the treatment to remove or thin the organic film 15 is performed before the connection step with an adhesive, so that the conductive particles break easily through the organic film 15 that has been hardened by the solder reflow treatment. So, even if the connection structure C using an adhesive is formed after the organic film 15 is passed through the solder reflow furnace, it is possible to more assuredly minimize the electrical connection resistance between the electrodes 12 and 22.

Furthemore, there is no need to strictly control the average thickness of the organic film 15 or the area proportion of a region having a small thickness at the time of the OSP treatment.

In summary, in this embodiment, the following effects are provided.

(1) In the connection structure C using an adhesive according to this embodiment, the surfaces of the electrodes 22, which are located on the mother board 20, for connection using an adhesive and the surfaces of the electrodes 12, which are located on the FPC 10, for connection using an adhesive are subjected to the OSP treatment to form the organic films 15 serving as oxidation preventing films. According to this structure, a process of forming the oxidation preventing films is simplified, as compared with the case where the electrodes 12 and 22 for connection using an adhesive are covered with gold plating layers. Furthermore, the material cost is reduced, as compared with the case of using a noble metal, such as gold. It is thus possible to connect the electrodes 12 and 22 for connection using an adhesive to each other at low production cost.

In addition, even if the organic film 15 is hardened by the solder reflow treatment or exposure of ultraviolet rays, the treatment to remove or thin the organic film 15 is performed before the connection using the adhesive 30 is established, so that the electrically conductive particles 36 break easily through the organic film 15. It is thus possible to suppress the degradation in the electrical conduction properties between the electrodes 12 and 22 for connection using an adhesive due to the fact that the electrically conductive particles 36 do not break through the organic film 15. Furthermore, there is no need to strictly control the average thickness of the organic film 15 or the area proportion of a region having a small thickness at the time of the OSP treatment.

(2) In this embodiment, the electrically conductive particles 36 in the adhesive 30, which is an anisotropic conductive adhesive, are formed of needle-shaped metal powder particles or a metal powder having a form in which many fine metal particles are connected in the form of a straight chain. According to this structure, the insulation between adjacent electrodes 22 for connection using an adhesive or between adjacent electrodes 12 for connection using an adhesive is maintained to prevent a short circuit with respect to the Y direction, which is the planar direction of the adhesive 30. Furthermore, each of many electrodes 22 for connection using an adhesive is connected to a corresponding one of the electrodes 12 for connection using an adhesive in one operation with respect to the X direction, which is the thickness direction of the adhesive 30, thereby resulting in a low resistance.

(3) In this embodiment, the electrically conductive particles 36 have an aspect ratio of 5 or more. According to this structure, when the anisotropic conductive adhesive is used, the contact probability between the electrically conductive particles 36 is increased. It is thus possible to facilitate electrical connection between the electrodes 12 and 22 for connection using an adhesive without increasing the blending quantity of the electrically conductive particles 36.

(4) In this embodiment, an adhesive having a film-like shape is used as the adhesive 30 (anisotropic conductive adhesive) before the formation of the connection structure C using an adhesive. In this structure, the anisotropic conductive adhesive is easily handled. Furthermore, workability when the connection structure C using an adhesive is formed by the heat and pressure treatment is improved.

(5) In this embodiment, major axes of the electrically conductive particles 36 are oriented in the X direction, which is the thickness direction of the adhesive 30 (anisotropic conductive adhesive) having a film-like shape. According to this structure, the insulation between adjacent electrodes 22 for connection using an adhesive or between adjacent electrodes 12 for connection using an adhesive is maintained to prevent a short circuit with respect to the Y direction, which is the planar direction of the adhesive 30. Furthermore, each of many electrodes 22 for connection using an adhesive is connected to a corresponding one of the electrodes 12 for connection using an adhesive in one operation with respect to the X direction, which is the thickness direction of the adhesive 30, thereby resulting in a low resistance. (6) In this embodiment, the flexible printed circuit board (FPC 10) is connected to the rigid printed wiring board (PWB), which is the mother board 20. According to this structure, it is possible to provide a multilayer conductive pattern structure at low cost, as compared with the case where the mother board 20 is an FPC. Furthermore, since the FPC 10 is connected onto the mother board 20, as illustrated in Fig. 2, the flexibility of arrangement of another substrate can be improved when the FPC 10 is connected to a connector of another substrate, as compared with the case where a rigid printed wiring board is connected thereto in place of the FPC 10. In addition, the electrodes 12 and 22 for connection using an adhesive are covered with the organic films 15 at low cost compared with that in the case where the electrodes 12 and 22 for connection using an adhesive are covered with gold plating films. It is thus possible to provide a connection body of the mother board 20 and the FPC 10 at low cost.

The foregoing embodiment may be changed as described below.

- In the foregoing embodiment, while the rigid printed wiring board (PWB) is used as the mother board 20, another structure may be used. For example, a flexible printed circuit board (FPC) may be used as the mother board 20.
- In the foregoing embodiment, while the connection structure C using an adhesive is used to connect the electrode of the FPC 10 to the electrode of the mother board 20, which is a PWB, the connection structure using an adhesive of the present invention is not limited thereto. For example, the connection structure C using an adhesive may be used to connect a protruding electrode (or a bump), serving as a conductor, of an electronic component, such as an IC chip, to an electrode on a PWB or FPC.
- A PWB may be mounted on the mother board 20 in place of the FPC 10 according to the foregoing embodiment. Furthermore, an electronic component may be mounted in place of the FPC 10.
- While the electrodes 12 and 22 for connection using an adhesive are subjected to the aqueous preflux treatment serving as the OSP treatment in the foregoing embodiment, heat-resistant preflux treatment may be performed as the OSP treatment. Furthermore, while the acidic aqueous solution containing an azole compound is used in the aqueous preflux treatment, another aqueous solution may be used.
- In the foregoing embodiment, both the electrodes 12 and 22 for connection using an adhesive are subjected to the OSP treatment. However, for example, only one of the electrodes 12 and 22 for connection using an adhesive may be subjected to the OSP treatment. In such a case, a noble metal plating layer, such as a gold plating layer, is formed on the other electrode 22 or 12 for connection using an adhesive. In this case, it is also possible to provide the effect (1) of the foregoing embodiment.

Examples According to First Embodiment

The present invention will be described below on the basis of examples and comparative examples according to the first embodiment. The present invention is not limited to these examples. These examples may be modified or altered on the basis of the purpose of the invention. The modifications and alterations are not excluded from the scope of the invention.

(Example 1 According to First Embodiment)

(Preparation of Adhesive)

Straight-chain fine nickel particles were used as electrically conductive particles, the major axis L being in the range of 1 $\mu$m to 10 $\mu$m, and the minor axis R being in the range of 0.1 $\mu$m to 0.4 $\mu$m. Two types of bisphenol A-type solid epoxy resin [trade name: (1) Epikote 1256 and (2) Epikote 1004, manufactured by Japan Epoxy Resin Co. Ltd.] and a naphthalene-type epoxy resin [trade name: (3) EPICLON 4032D, manufactured by Dainippon Ink and Chemicals] were used as insulating thermosetting resins. Furthermore, a thermoplastic polyvinyl butyral resin [trade name: (4) S-LEC BM-1, manufactured by SEKISUI CHEMICAL CO., LTD.] was used. (5) A microencapsulated imidazole-type hardener [trade name: NOVACURE HX3941, manufactured by Asahi Kasei Epoxy Co., Ltd.] was used as a microencapsulated latent hardener. These components (1) to (5) were mixed in a weight ratio of (1)35/(2)20/(3)25/(4)10/(5)30.

The epoxy resins, the thermoplastic resin, and the latent hardener were dissolved or dispersed in cellosolve acetate. The resulting mixture was kneaded with three rolls, thereby preparing a solution having a solid content of 50% by weight. The Ni powder described above was added to the solution in such a manner that a metal-filling factor, which is indicated by the proportion of the metal in the total solid content (Ni powder + resins), was 0.05% by volume. Then the mixture was agitated with a centrifugal type agitating mixer to uniformly disperse the Ni powder, thereby preparing a composite material for an adhesive agent. The resulting composite material was applied with a doctor knife onto a polyethylene terephthalate (PET) film that had been subjected to treatment of parting. The applied composite material was dried and solidified at 60°C for 30 minutes in a magnetic field having a magnetic flux density of 100 mT, thereby forming a 25-$\mu$m-thick anisotropic conductive film adhesive in which straight-chain particles in the film were oriented in the direction of the magnetic field.

(Production of Printed Wiring Board)

A flexible printed wiring board in which 30 electrodes for connection using an adhesive, the electrodes being copper electrodes each having a width of 150 $\mu$m, a length of 4 mm, and a height of 18 $\mu$m, were spaced at 150 $\mu$m, was prepared. Oxidation preventing films containing 2-phenyl-4-methyl-5-benzylimidazole were formed by OSP treatment on the electrodes for connection using an adhesive. The oxidation preventing films each had a decomposition temperature of 310°C and an average thickness of 0.10 $\mu$m. The proportion of the area of a region having a thickness of 0.1 $\mu$m or less was 60%.

(Evaluation of Connection Resistance)

The flexible printed wiring board was subjected to solder reflow treatment at a peak temperature of 260°C in a reflow tank having an oxygen concentration of 1% or less achieved by allowing nitrogen to flow.
Subsequently, the electrodes for connection using an adhesive were immersed in hydrochloric acid (30°C, pH = 4) for 1 minute to remove the oxidation preventing films. Then the flexible printed wiring boards were faced to each other in such a manner that a daisy chain in which connection resistances were able to be measured at continuous 30 points was formed. The resulting adhesive was arranged between the flexible printed wiring boards. The flexible printed wiring boards were bonded at 190°C by pressing at a pressure of 5 MPa for 15 seconds, thereby producing a joint body of the flexible printed wiring boards.
Next, in the joint body, resistances at the continuous 30 points connected through the electrodes for connection using an adhesive, the adhesive, and the electrodes for connection using an adhesive were determined by a four-terminal method. The resulting value was divided by 30 to determine a connection resistance per point. The evaluation was repeated 10 times, and then the average connection resistance was calculated. It was determined that when the connection resistance was 50 m$\Omega$ or less, the electrical conduction was ensured.

(Evaluation of Connection Reliability)

After the resulting connection body was allowed to stand in a high temperature and high humidity tank at 85°C and 85% RH for 500 hr, the connection resistance was measured as described above. It was determined that when the rate of increase in connection resistance was 50% or less, the connection reliability was satisfactory.

(Example 2 According to First Embodiment)

A joint body of flexible printed wiring boards was produced as in Example 1, except that the oxidation preventing films each had an average thickness of 0.60 $\mu$m and that the proportion of the area of a region having a thickness of 0.1 $\mu$m or less was 2%. Then the evaluation of the connection resistance and the evaluation of the connection reliability were made under conditions the same as those of Example 1.

(Comparative Example 1)

A joint body of flexible printed wiring boards was produced as in Example 2, except that the immersion treatment in the hydrochloric acid was not performed after the solder reflow treatment. Then the evaluation of the connection resistance and the evaluation of the connection reliability were made under conditions the same as those of Example 1.

(Measurement of Decomposition Temperature)

The decomposition temperature was measured with a differential scanning calorimetry (DSC). An exothermic onset temperature at a heating rate of 10 °C/min is defined as a decomposition temperature.

(Thickness Measurement)

Cross sections of the electrodes for connection using an adhesive are observed, the electrodes being covered with the oxidation preventing films. The thicknesses were measured at intervals of 0.2 $\mu$m, and then the proportion of the area of a region having an average thickness of 0.1 $\mu$m or less is calculated.

[Table 1]

|  | Initial connection resistance (m$\Omega$) | Rate of increase in resistance (%) |
| --- | --- | --- |
| Example 1 | 40 | 4 |
| Example 2 | 41 | 5 |
| Comparative Example 1 | 150 | $\infty$ |

Table 1 shows the results of the evaluations of the connection resistance and the connection reliability in Examples 1 and 2 according to the first embodiment and the comparative example.

As shown in Table 1, in each of the Examples 1 and 2 according to the first embodiment, the initial connection resistance is 50 m$\Omega$ or less. The connection resistance is sufficiently small, which is satisfactory. Furthermore, in each of Examples 1 and 2 according to the first embodiment, the rate of increase in resistance is 50% or less. This demonstrates that the connection reliability is also satisfactory.

In contrast, in Comparative Example 1, the initial connection resistance was 50 m$\Omega$ or more, which was high. After the sample was allowed to stand in the high temperature and high humidity tank for 500 hours, the connection was open, and the rate of increase in resistance was $\infty$ (infinite). The reason for this is presumably that despite the hardening of the oxidation preventing films according to Comparative Example 1 by the solder reflow treatment, the treatment to remove or thin the oxidation preventing films was not performed, so that the electrically conductive particles did not break surely through the oxidation preventing films, thereby leading to unstable contact between the electrically conductive particles and the electrodes for connection using an adhesive.

Furthermore, the initial connection resistance and the rate of increase in resistance in Example 1 according to the first embodiment were substantially the same as those in Example 2 according to the first embodiment. The results thus demonstrate that as described in Example 2, even at an average thickness of 0.5 $\mu$m or more and a small area proportion of a region having a thickness of 0.1 $\mu$m or less, by performing the treatment to remove or thin the oxidation preventing films, a low initial connection resistance and high connection reliability can be maintained.

- Connection Structure Using Adhesive According to First Example of Second Embodiment -

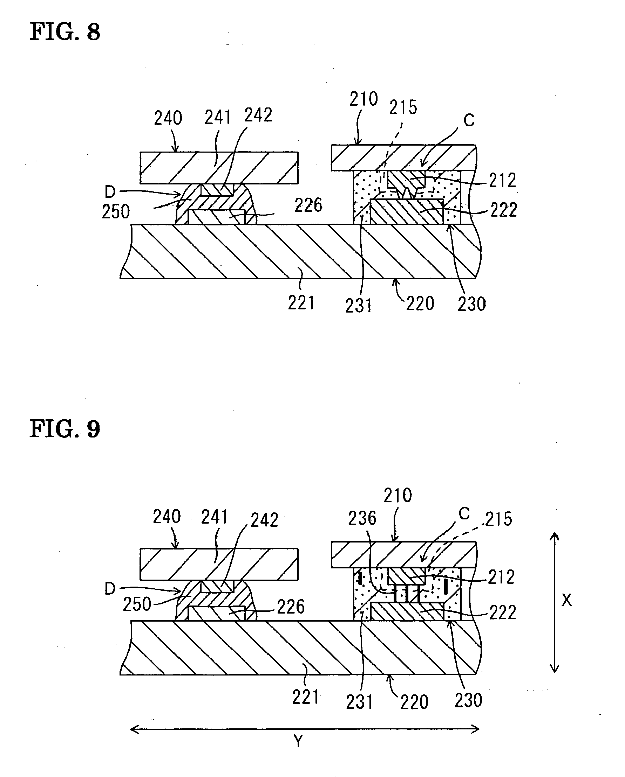

Figure 8 is a cross-sectional view illustrating a connection structure C using an adhesive and a connection structure D using solder according to a first example of a second embodiment, the connection structure C using an adhesive being arranged between a flexible printed circuit board 210 (FPC 210) and a mother board 220, and the connection structure D using solder being arranged between an electronic component 240 and the mother board 220. The connection structure C using an adhesive is formed with a non-conductive adhesive (NCA).

The mother board 220 includes a rigid printed wiring board 221, an electrode 222 for connection using an adhesive, and an electrode 226 for connection using solder, these electrodes being arranged on the rigid printed wiring board 221. The mother board 220 is a rigid printed wiring board (PWB) corresponding to the display section substrate 135 or the input key board 145 illustrated in Fig. 2. The FPC 210 is mounted on the mother board 220 in such a manner that an electrode 212 for connection using an adhesive (connection conductor) is directed below a base film 211. The electronic component 240 includes a chip 241 having a portion where a chip-side electrode 242 (connection conductor using solder) is arranged, the chip-side electrode 242 being directed below the chip 241.

The electrode 222 for connection using an adhesive and the electrode 226 for connection using solder on the mother board 220 are formed by laminating metallic foil, such as copper foil, on the rigid printed wiring board 221 and subjecting the metallic foil to lithographic exposure and etching in the usual manner.

In the connection structure C using an adhesive, both the electrodes 212 and 222 are tightly contacted by a constricting force of an adhesive 230, which is an NCA, and are conductive with each other. In the connection structure D using solder; by alloying of a solder layer 250 and the electrodes 226 and 242, both the electrodes 226 and 242 are conductive with each other.

The adhesive 230 contains a thermosetting resin, which is a main component, a curing agent, and various types of fillers. The constituents and so forth are the same as those of the adhesive 30 according to the first embodiment, and thus will not be described.

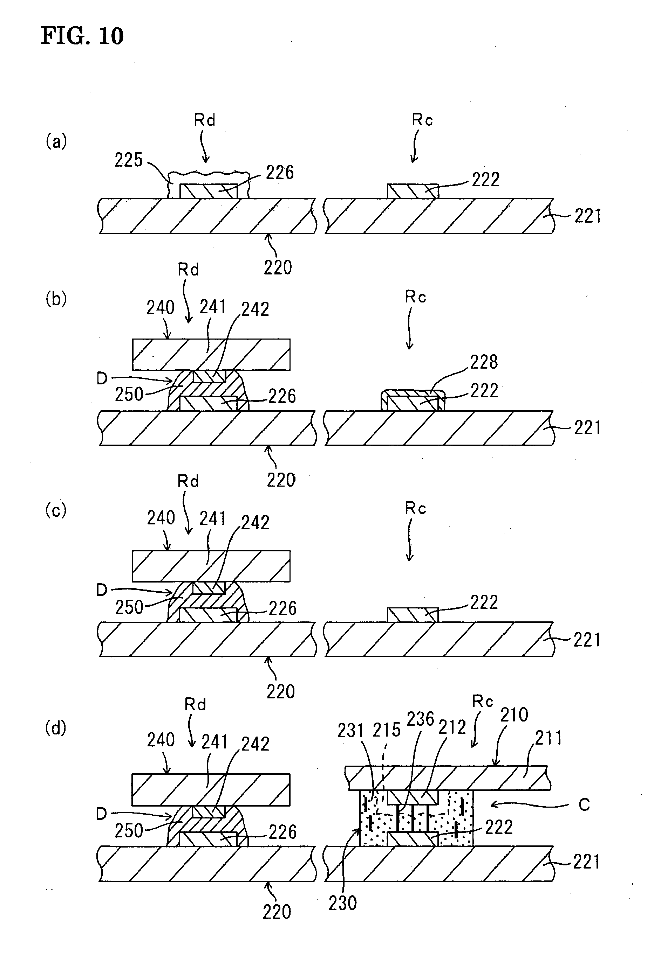

Before the formation of the connection structure C using an adhesive and the connection structure D using solder, the electrodes 226 and 242 for connection using solder are covered with organic films formed by OSP treatment described below. In a solder reflow step, the organic films on the electrode 226 for connection using solder and the electrode 242 for connection using solder are dissolved in the solder layer 250. Meanwhile, protective films similar to the organic films 15 illustrated in Fig. 3 have been bonded to the electrode 222 for connection using an adhesive and the electrode 212 for connection using an adhesive. After the completion of the solder reflow step, the protective films are removed (see Figs. 10(b) and 10(c) described below).

Note that an organic film 215 formed by the OSP treatment may be arranged on a surface of the electrode 212 for connection using an adhesive (see a dotted line in Fig. 8). If the FPC 210 is not subjected to the solder reflow treatment, the organic film 215 need not have a higher decomposition temperature than the temperature of the solder reflow treatment.

To establish a connection using the adhesive 230, after removal of the thermally decomposed organic film, the adhesive 230 is melted by heating while the adhesive 230 is pressurized toward the mother board 220 at a predetermined pressure via the FPC 210 (heat and pressure treatment). Thereby, the thermosetting resin in the adhesive 230 is cured, so that the electrodes 212 and 222 on the FPC 210 and the mother board 220, respectively, are tightly contacted by a constricting force due to its contraction and are conductive with each other. In this case, a portion (electrically conductive portion) of the electrode 212 for connection using an adhesive is not covered with the organic film 215, so that electrical conduction is established.

In this embodiment, the electrode 212 for connection using an adhesive on the FPC 210 is processed by etching so as to have a rough surface. Note that machining, such as embossing, may be employed in addition to the etching.

In the case where the electrode 212 is covered with the organic film 215, when a protruding portion is arranged on a surface of at least one of the electrodes, the protruding portion breaks through the organic film 215. Hence, the electrodes 212 and 222 are assuredly contacted to each other. If the organic film 215 is not formed, the electrode 212 for connection using an adhesive need not necessarily be processed so as to have a rough surface. However, the contact is more easily established by the roughening process. A bump may be arranged between the electrodes 212 and 222.

According to the first example of the second embodiment, the following effects are provided in addition to the effects of the electrode structure.

For example, in the case where the electrode 222 for connection using an adhesive is covered with an organic film formed by OSP treatment described below, when the mother board 220 is subjected to the solder reflow step, the organic film is hardened. In this case, the electrical connection resistance between the electrodes 212 and 222 can be increased. In particular, if heating is performed in the solder reflow furnace, the organic film is liable to be hardened.

Thus, the protruding portion of the electrode 212 for connection using an adhesive is less likely to break through the hardened organic film, leading to an increase in connection resistance.

In contrast, in this embodiment, the connection step is performed without forming an organic film on the electrodes 212 and 222. So, the protruding portion of the electrode 12 for connection using an adhesive comes easily into contact with the electrode 222 for connection using an adhesive.

Also in the case where the organic film 215 is formed on the electrode 212 for connection using an adhesive, when the FPC 210 is not subjected to the solder reflow step, the organic film 215 is not hardened, so that the protruding portion of the electrode 212 for connection using an adhesive breaks easily through the organic film. When the FPC 210 is subjected to the solder reflow step, a protective film is preferably bonded on the electrode 212 for connection using an adhesive as described in this embodiment.

Accordingly, it is possible to inhibit the occurrence of defective conduction (e.g., an increase in connection resistance) between the electrode 212 for connection using an adhesive and the electrode 222 (connection conductor) for connection using an adhesive.

- Connection Structure Using Adhesive According to Second Example of Second Embodiment -

Figure 9 is a cross-sectional view illustrating a connection structure C using an adhesive and a connection structure D using solder according to a second example of the second embodiment. In the connection structure C using an adhesive, the adhesive 230, which is an anisotropic conductive adhesive (ACA), is used. That is, the adhesive 230 used in this example contains electrically conductive particles 236 in a resin composition 231 mainly composed of a thermosetting resin.

Also in this example, the mother board 220 includes the rigid printed wiring board 221 and the electrode 222 for connection using an adhesive and the electrode 226 for connection using solder, these electrodes being arranged on the rigid printed wiring board 221. Also in this example, neither gold plating layer nor organic film formed by OSP treatment is arranged on a surface of the electrode 212 for connection using an adhesive or a surface of the electrode 222 for connection using an adhesive.

The electrodes 212 and 222 are electrically connected to each other through the electrically conductive particles 236. The electrically conductive particles 236 are formed of needle-shaped metal powder particles or a metal powder having a form in which many fine metal particles are connected in the form of a straight chain.

Similarly to the first example of the second embodiment, also in this example, the electrodes 212 and 222 may be directly contacted to each other.

Also in this example, before the formation of the connection structure C using an adhesive and the connection structure D using solder, the electrodes 226 and 242 are covered with organic films similar to the organic films 15 illustrated in Fig. 3. In a solder reflow step, the organic films on the electrode 226 for connection using solder and the electrode 242 for connection using solder are dissolved in the solder layer 250. Meanwhile, detachable protective films have been arranged on the electrode 222 for connection using an adhesive and the electrode 212 for connection using an adhesive. After the solder reflow step, the protective films are removed.

Note that the organic film 215 indicated by a dotted line in the figure may be arranged on the electrode 222 for connection using an adhesive on the FPC 210.

When a connection is established, the thermosetting resin in the adhesive 230 is cured by the heat and pressure treatment. The electrodes 212 and 222 are connected to each other through the electrically conductive particles 236 by a constricting force due to its contraction.

In this example, the electrically conductive particles 236 each having a needle shape or having a form in which many fine metal particles are connected in the form of a straight chain are contained in the resin composition 231 from the beginning.

However, electrically conductive particles formed of fine metal particles dispersed in the resin composition 231 in a random manner may be used. This is because also in that case, the heat and pressure treatment causes the fine metal particles to have a form in which many fine metal particles are connected between the electrodes 212 and 222.

As the anisotropic conductive adhesive used in the second example of the second embodiment, similar to the second example of the first embodiment, a commonly used adhesive, i.e., an adhesive containing the electrically conductive particles 36 dispersed in a resin composition mainly composed of an insulating thermosetting resin, such as an epoxy resin, may be used. The constituents and so forth are the same as in the second example of the first embodiment, and thus will not be described.

According to the second example of the second embodiment, neither organic film formed by OSP treatment nor noble metal plating layer, such as a gold plating layer, is arranged on the electrodes 212 and 222 for connection using an adhesive. This provides the same effects as in the first example of the second embodiment. In this example, however, the electrodes 212 and 222 are conductive with each other through the electrically conductive particles 236.

As the anisotropic conductive adhesive, an adhesive having the shape illustrated in Fig. 6 according to the first embodiment may be used.

- Connection Method According to Second Embodiment -

Figures 10(a) to 10(d) are cross-sectional views illustrating the procedure of a connection method for forming a connection structure C using an adhesive and a connection structure D using solder according to the first example of the second embodiment.

In a step illustrated in Fig. 10(a), the mother board 220 (common base material) including a region Rc for connection using an adhesive and a region Rd for connection using solder is prepared. In the mother board 220, the electrode 222 for connection using an adhesive is provided in the region Rc for connection using an adhesive, and an electrode 226 for connection using solder is provided in the region Rd for connection using solder.

Next, an organic film 225 is formed so as to cover only the electrode 226 for connection using solder. Neither gold plating layer nor organic film is formed on the electrode 222 for connection using an adhesive. Alternatively, a detachable protective film 228 is formed so as to cover the electrode 222 for connection using an adhesive. Specifically, the electrode 222 for connection using an adhesive is covered with, for example, an adhesive tape. The protective film 228 other than the adhesive tape may be used. In that case, the protective film is required to withstand the temperature of the solder reflow treatment and be detachable.

The organic film 225 is formed by aqueous preflux treatment (organic solderability preservation (OSP) treatment) similarly to the first embodiment.

Next, in a step illustrated in Fig. 10(b), the electronic component 240 having the chip-side electrode 242 located in a portion of the chip 241 is arranged in the region Rd for connection using solder. At this point, the chip-side electrode 242 is aligned with the electrode 226 for connection using solder, and lead-free solder is provided between the electrodes 226 and 242. Then the mother board 220 and the electronic component 240 are placed in a solder reflow furnace having a peak temperature of about 260°C to reflow the solder. Thus, the electrodes 226 and 242 are joined to each other through the solder layer 250 to electrically connect the electrodes 226 and 242 to each other.

Thereby, the connection structure D using solder is formed in the region Rd for connection using solder.

The organic film 225 that has covered the electrode 226 for connection using solder reacts with flux contained in the lead-free solder to dissolve into the solder layer 250.

Next, in a step illustrated in Fig. 10(c), the protective film 228 on the electrode 222 for connection using an adhesive is removed to expose the electrode 222 for connection using an adhesive.

Before a lapse of about 3 days after the step illustrated in Fig. 10(c), in a step illustrated in Fig. 10(d), the electrode 222 for connection using an adhesive is bonded to the electrode 212, which is located on the FPC 210, for connection using an adhesive, with the adhesive 230 to establish electrical connection. Thereby, the connection structure C using an adhesive is formed in the region Rc for connection using an adhesive. The procedure for the formation of the connection structure C using an adhesive is the same as that described in the connection structure using an adhesive according to the second example of the second embodiment (see Fig. 9).

In the case where the electrode 222 for connection using an adhesive is oxidized in the solder reflow step, no failure occurs even if a long period of time, i.e., 3 days or more, elapses after the step illustrated in Fig. 10(c) as long as a step of removing an oxide film is performed before the step illustrated in Fig. 10(d).

In this embodiment, a protective film has also been arranged on the electrode 212 for connection using an adhesive on the FPC 210. Immediately before establishing the connection using the adhesive 230, the protective film is removed.

As described above, the adhesive 230 (anisotropic conductive adhesive) containing the electrically conductive particles 236 is mainly composed of a thermosetting resin. Thus, when the anisotropic conductive adhesive is heated, the anisotropic conductive adhesive is temporarily softened. When the heating is continued, the anisotropic conductive adhesive is cured. After a predetermined curing time of the anisotropic conductive adhesive, a pressurized state and a state in which the curing temperature of the anisotropic conductive adhesive is maintained are released, and then cooling is started. Thereby, the electrodes 212 and 222 are connected to each other through the electrically conductive particles 236 in the adhesive 230 to mount the FPC 210 on the mother board 220.

Figures 10(a) to 10(d) illustrate an example of the formation of the connection structure C using an adhesive and the connection structure D using solder on the mother board 220 serving as a PWB.

Alternatively, the FPC 210 may be used as a common base material, and the connection structure C using an adhesive and the connection structure D using solder may be formed on the FPC 210. In that case, the mother board 220 illustrated in Fig. 10 is replaced with the FPC 210, and the organic film 215 is formed on the electrode 212 for connection using an adhesive. The procedure is the same as that described above.

Note that there are a single-sided circuit structure and a double-sided circuit structure in FPCs. For the FPC having the double-sided circuit structure, the FPC is passed through the solder reflow furnace twice.

In the connection method according to the second embodiment, the following effects are provided.

Usually, in the case where connection using solder and connection using an adhesive are performed on the same substrate, after the organic films 225 are formed on the electrode 226 for connection using solder and the electrode 222 for connection using an adhesive, the connection using solder is first established, and then the connection using an adhesive is established. This is because if the connection using an adhesive is first established, the constriction of the adhesive is loosened during the subsequent solder reflow, so that poor connection is more likely to occur.

Meanwhile, in the case where the connection structure C using an adhesive is formed after the solder reflow step, the connection resistance between the electrodes 212 and 222, which are electrically connected to each other, can be increased, as compared with the case where it is not passed through the solder reflow furnace. This is presumably because the organic films 225 are altered (e.g., hardened) by heating in the solder reflow furnace, so that the electrically conductive particles 236 are less likely to break through the organic films.

In the connection method according to this embodiment, the detachable protective film 228 is formed on the electrode 222 for connection using an adhesive without forming an organic film. In the step illustrated in Fig. 10(b), the solder reflow step is performed while a surface of the electrode 222 for connection using an adhesive is covered with the protective film 228 to suppress the formation of an oxide film. After the solder reflow treatment, the protective film 228 is removed in the step illustrated in Fig. 10(c).

Thus, in the step illustrated in Fig. 10(d), the electrically conductive particles 236 in the adhesive 230 come easily into contact with the electrodes 212 and 222 for connection using an adhesive without an organic film, so that the electrodes 212 and 222 for connection using an adhesive are surely conductive with each other.

So, even if the connection structure C using an adhesive is formed after the organic films 215 and 225 are passed through the solder reflow furnace, it is possible to more assuredly minimize the electrical connection resistance between the electrodes 212 and 222.

In the step illustrated in Fig. 10(a), a noble metal plating layer, such as a gold plating layer, may be arranged as an oxidation preventing film on the electrode 226 for connection using solder. However, the formation of the organic film 225 formed by the OSP treatment provides the effects described below.

Note that also in the case where a noble metal plating layer, such as a gold plating layer, is arranged as an oxidation preventing films on the electrode 226 for connection using solder, there is no need to perform the OSP treatment to cover the electrode 222 for connection using an adhesive. This provides the effect of reducing the production cost.

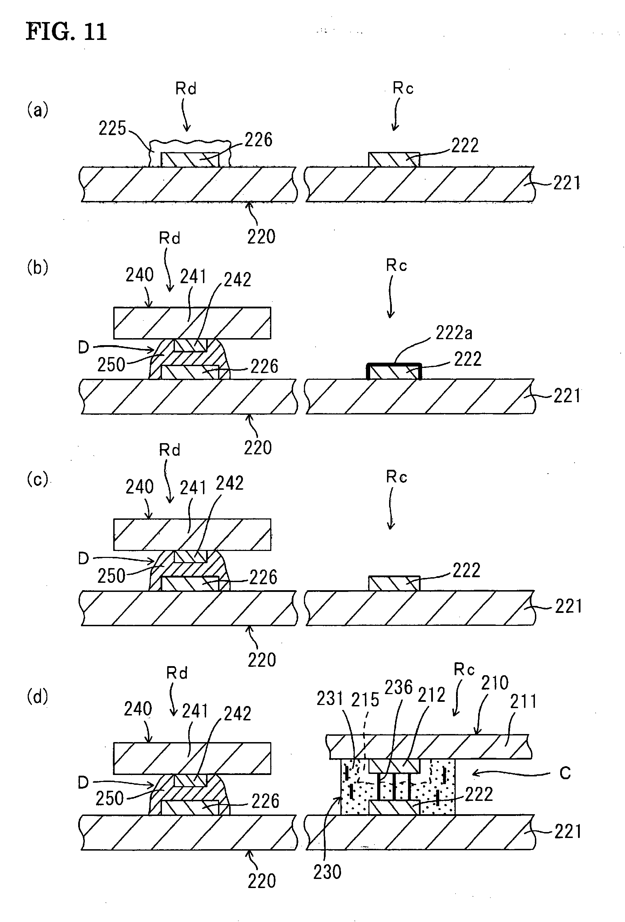

Figures 11(a) to 11(d) are cross-sectional views illustrating the procedure of a connection method for forming a connection structure C using an adhesive and a connection structure D using solder according to the second example of the second embodiment. In Fig. 11, the same members as those in Fig. 10 are designated using the same reference numerals, and descriptions are omitted.

In Figs. 11(a) to 11(d), the steps are basically performed in the same procedure as that in the first example of the second embodiment as illustrated in Figs. 10(a) to 10(d). So, the descriptions of the same steps as that in the first example of the second embodiment are omitted, and only different steps will be described.

In a step illustrated in Fig. 11(a), even a protective film is not arranged on the electrode 222 for connection using an adhesive. Thus, a thin oxide film 222a is formed on the electrode 222 for connection using an adhesive in a solder reflow step illustrated in Fig. 11(b).

However, in the case where an atmosphere in a solder reflow furnace is maintained to be a non-oxidizing atmosphere having an extremely low oxygen concentration (for example, 1% or less), the thickness of the oxide film can be negligibly thin.

In a step illustrated in Fig. 11(c), the oxide film 222a is removed. Examples of a method for removing the oxide film 222a include washing with an acidic solution; and plasma cleaning.

As described above, because a step of removing the oxide film 222a is performed, there is no need to worry about a storage period after the solder reflow treatment as described in the first example.

Thus, similarly to the first example of the second embodiment, in a step illustrated in Fig. 11(d), the electrically conductive particles 236 in the adhesive 230 come easily into contact with the electrodes 212 and 222 for connection using an adhesive without an organic film, so that the electrodes 212 and 222 for connection using an adhesive are surely conductive with each other.

In this example, although a protective film is not formed on the electrode 222 for connection using an adhesive, the resulting oxide film 222a is removed. It is thus possible to assuredly suppress an increase in the connection resistance between the electrodes 212 and 222. So, the method according to the second example of the second embodiment basically provides the same effects as those by the method according to the first example of the second embodiment.

In summary, in this embodiment, the following effects are provided.

(1) In the connection structure C using an adhesive according to this embodiment, a surface of the electrode 222, which is located on the mother board 220, for connection using an adhesive and a surface of the electrode 212, which is located on the FPC 210, for connection using an adhesive are not subjected to OSP treatment. Furthermore, a noble metal plating layer, such as gold plating, is not formed. Thus, the simplification of the process and a reduction in material cost result in a reduction in production cost.

Moreover, the electrically conductive particles 236 come easily into contact with the electrodes 212 and 222 for connection using an adhesive at the time of establishing a connection using the adhesive 230 because an organic film formed by OSP treatment is not present on each of the electrodes 212 and 222 for connection using an adhesive. It is thus possible to suppress the degradation in the electrical conduction properties between the electrodes 212 and 222 due to the fact that the electrically conductive particles 236 do not break through an organic film.

(2) In this embodiment, the electrically conductive particles 236 in the adhesive 230, which is an anisotropic conductive adhesive, are formed of needle-shaped metal powder particles or a metal powder having a form in which many fine metal particles are connected in the form of a straight chain. According to this structure, the insulation between adjacent electrodes 222 for connection using an adhesive or between adjacent electrodes 212 for connection using an adhesive is maintained to prevent a short circuit with respect to the Y direction, which is the planar direction of the adhesive 230. Furthermore, each of many electrodes 222 for connection using an adhesive is connected to a corresponding one of the electrodes 212 for connection using an adhesive in one operation with respect to the X direction, which is the thickness direction of the adhesive 230, thereby resulting in a low resistance.

(3) In this embodiment, the electrically conductive particles 236 have an aspect ratio of 5 or more. According to this structure, when the anisotropic conductive adhesive is used, the contact probability between the electrically conductive particles 236 is increased. It is thus possible to facilitate electrical connection between the electrodes 212 and 222 without increasing the blending quantity of the electrically conductive particles 236.

(4) In this embodiment, an adhesive having a film-like shape is used as the adhesive 230 (anisotropic conductive adhesive) before the formation of the connection structure C using an adhesive. In this structure, the anisotropic conductive adhesive is easily handled. Furthermore, workability when the connection structure C using an adhesive is formed by the heat and pressure treatment is improved.

(5) In this embodiment, major axes of the electrically conductive particles 236 are oriented in the X direction, which is the thickness direction of the adhesive 230 (anisotropic conductive adhesive) having a film-like shape. According to this structure, the insulation between adjacent electrodes 222 for connection using an adhesive or between adjacent electrodes 212 for connection using an adhesive is maintained to prevent a short circuit with respect to the Y direction, which is the planar direction of the adhesive 230. Furthermore, each of many electrodes 222 for connection using an adhesive is connected to a corresponding one of the electrodes 212 for connection using an adhesive in one operation with respect to the X direction, which is the thickness direction of the adhesive 230, thereby resulting in a low resistance.

(6) In this embodiment, the flexible printed circuit board (FPC 210) is connected to the rigid printed wiring board (PWB), which is the mother board 220. According to this structure, it is possible to provide a multilayer conductive pattern structure at low cost, as compared with the case where the mother board 220 is an FPC. Furthermore, since the FPC 210 is connected onto the mother board 220, as illustrated in Fig. 2, the flexibility of arrangement of another substrate can be improved when the FPC 10 is connected to a connector of another substrate, as compared with the case where a rigid printed wiring board is connected thereto in place of the FPC 210. In addition, simply, the protective film (adhesive tape) is bonded to the electrodes 212 and 222 for connection using an adhesive, or the oxide film is removed by acid treatment or the like. This can be performed at low cost compared with the case where the electrodes 212 and 222 are covered with gold plating films or subjected to OSP treatment. It is thus possible to provide a connection body of the mother board 220 and the FPC 210 at low cost.

The foregoing embodiment may be changed as described below.

- In the foregoing embodiment, while the rigid printed wiring board (PWB) is used as the mother board 220, another structure may be used. For example, a flexible printed circuit board (FPC) may be used as the mother board 220.
- In the foregoing embodiment, while the connection structure C using an adhesive is used to connect the electrode of the FPC 210 to the electrode of the mother board 220, which is a PWB, the connection structure using an adhesive of the present invention is not limited thereto. For example, the connection structure C using an adhesive may be used to connect a protruding electrode (or a bump), serving as a conductor, of an electronic component, such as an IC chip, to an electrode on a PWB or FPC.
- A PWB may be mounted on the mother board 220 in place of the FPC 210 according to the foregoing embodiment. Furthermore, an electronic component may be mounted in place of the FPC 210.
- While the electrodes 226 and 242 for connection using solder are subjected to the aqueous preflux treatment serving as the OSP treatment in the foregoing embodiment, heat-resistant preflux treatment may be performed as the OSP treatment. Furthermore, while the acidic aqueous solution containing an azole compound is used in the aqueous preflux treatment, another aqueous solution may be used.
- In the foregoing embodiment, neither organic film formed by OSP treatment nor noble metal plating layer is arranged on each of the electrodes 212 and 222 for connection using an adhesive. However, an organic film formed by OSP treatment or a noble metal plating layer may be arranged only on the electrode 212 for connection using an adhesive. In this case, it is also possible to provide the effect (1) of the foregoing embodiment.

Examples According to Second Embodiment

The present invention will be described below on the basis of examples and comparative examples according to the second embodiment. The present invention is not limited to these examples. These examples may be modified or altered on the basis of the purpose of the invention. The modifications and alterations are not excluded from the scope of the invention.

(Example 1 According to Second Embodiment)

(Preparation of Adhesive)

The preparation of an adhesive is the same as in Example 1 according to the first embodiment, and the description is omitted.

(Production of Printed Wiring Board)

A flexible printed wiring board in which 30 electrodes for connection using an adhesive, the electrodes being copper electrodes each having a width of 150 $\mu$m, a length of 4 mm, and a height of 18 $\mu$m, were spaced at 150 $\mu$m, was prepared. Each of the electrodes for connection using an adhesive was not covered with an organic film formed by OSP treatment or a noble metal plating layer.

(Evaluation of Connection Resistance)

The flexible printed wiring board was subjected to solder reflow treatment at a peak temperature of 260°C in a reflow tank having an oxygen concentration of 1% or less achieved by allowing nitrogen to flow. Then the flexible printed wiring boards were faced to each other in such a manner that a daisy chain in which connection resistances were able to be measured at continuous 30 points was formed. The resulting adhesive was arranged between the flexible printed wiring boards. The flexible printed wiring boards were bonded at 190°C by pressing at a pressure of 5 MPa for 15 seconds, thereby producing a joint body of the flexible printed wiring boards. Next, in the joint body, resistances at the continuous 30 points connected through the electrodes for connection using an adhesive, the adhesive, and the electrodes for connection using an adhesive were determined by a four-terminal method. The resulting value was divided by 30 to determine a connection resistance per point. The evaluation was repeated 10 times, and then the average connection resistance was calculated. It was determined that when the connection resistance was 50 mΩ or less, the electrical conduction was ensured.

(Evaluation of Connection Reliability)

The evaluation criterion is the same as in Example 1 according to the first embodiment, and the description is omitted.

(Example 2 According to Second Embodiment)

A joint body of flexible printed wiring boards was produced as in Example 1 according to the second embodiment, except that after the solder reflow treatment was performed, the electrodes for connection using an adhesive were washed with an acetic acid solution to remove oxide films before the formation of the joint body with the anisotropic conductive adhesive. Then the evaluation of the connection resistance and the evaluation of the connection reliability were made under conditions the same as those of Example 1.

(Comparative Example 1)

A joint body of flexible printed wiring boards was produced as in Example 1, except that oxidation preventing films containing 2-phenyl-4-methyl-5-benzylimidazole were formed on the electrodes for connection using an adhesive. The oxidation preventing films each had a decomposition temperature of 310°C and an average thickness of 0.60 $\mu$m. The proportion of the area of a region having a thickness of 0.1 $\mu$m or less was 4%. Then the evaluation of the connection resistance and the evaluation of the connection reliability were made under conditions the same as those of Example 1 according to the second embodiment.

(Comparative Example 2)

A joint body of flexible printed wiring boards was produced as in Example 1, except that the atmosphere in the reflow tank was an air atmosphere. Then the evaluation of the connection resistance and the evaluation of the connection reliability were made under conditions the same as those of Example 1.

(Measurement of Decomposition Temperature)

The procedure and so forth are the same as those in Example 2 according to the first embodiment, and the description is omitted.

(Thickness Measurement)

The procedure and so forth are the same as those in Example 2 according to the first embodiment, and the description is omitted.

[Table 2]

| | Initial connection resistance (mΩ) | Rate of increase in resistance (%) |
|---|---|---|
| Example 1 | 45 | 8 |
| Example 2 | 42 | 5 |
| Comparative Example 1 | 150 | ∞ |
| Comparative Example 2 | 820 | ∞ |

Table 2 shows the results of the evaluations of the connection resistance and the connection reliability in Examples 1 and 2 according to the second embodiment and the Comparative Examples 1 and 2.

As shown in Table 2, in each of the Examples 1 and 2 according to the second embodiment, the initial connection resistance is 50 mΩ or less. The connection resistance is sufficiently small, which is satisfactory. Furthermore, in each of Examples 1 and 2 according to the second embodiment, the rate of increase in resistance is 50% or less. This demonstrates that the connection reliability is also satisfactory.

In Comparative Example 1, the initial connection resistance was 50 mΩ or more, which was high. The rate of increase in resistance was ∞ (infinite). In Comparative Example 1, the electrodes for connection using an adhesive are covered with the oxidation preventing films at the time of the solder reflow treatment. So, no oxide film was formed on the electrodes for connection using an adhesive. However, the oxidation preventing films were hardened at the time of the solder reflow treatment, so that the electrically conductive particles did not break surely through the oxidation preventing films, thereby probably leading to unstable contact between the electrically conductive particles and the electrodes for connection using an adhesive.

In Comparative Example 2, the initial connection resistance was higher than that in Comparative Example 1. The rate of increase in resistance was ∞ (infinite). In Comparative Example 2, each electrode for connection using an adhesive was not covered with an oxidation preventing film at the time of the solder reflow treatment. Furthermore, the solder reflow treatment was performed in an oxidizing atmosphere, so that oxide films were formed on the electrodes for connection using an adhesive, thereby increasing the contact resistance between the electrodes and the electrically conductive particles.

Furthermore, comparisons of Examples 1 and 2 according to the second embodiment show substantially the same connection resistance and substantially the same rate of increase in resistance. The results thus demonstrate that as described in Example 1, the solder reflow treatment was simply performed in a non-oxidizing atmosphere so as not to form an oxide film on the electrodes for connection using an adhesive, thereby maintaining a low initial connection resistance and high connection reliability.

However, the initial connection resistance and the rate of increase in resistance in Example 2 according to the second embodiment were slightly superior to those in Example 1 according to the second embodiment. The results thus demonstrate that by performing the step of removing the oxide film as described in Example 2 according to the second embodiment, a low initial connection resistance and high connection reliability can be maintained.

- Connection Structure Using Adhesive According to First Example of Third Embodiment -

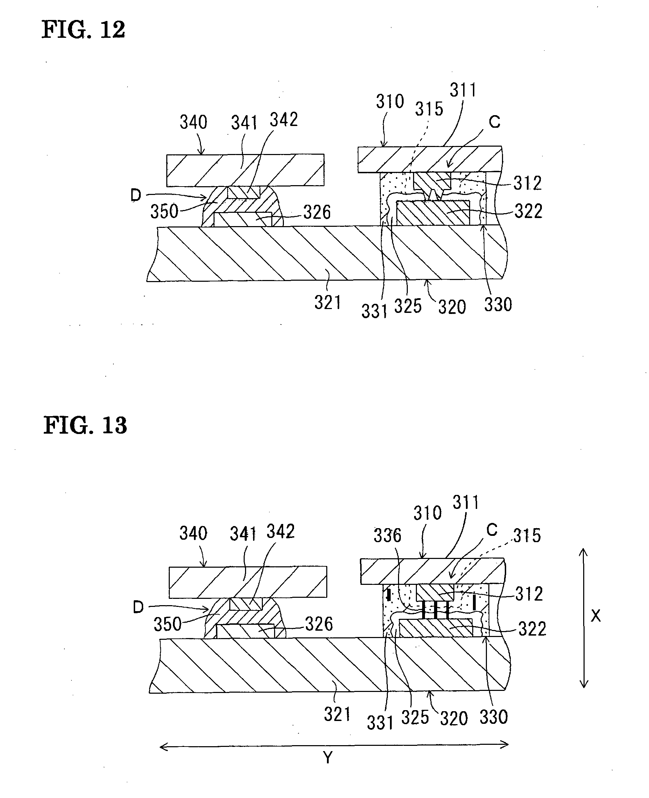

Figure 12 is a cross-sectional view illustrating a connection structure C using an adhesive and a connection structure D using solder according to a first example of a third embodiment, the connection structure C using an adhesive being arranged between a flexible printed circuit board 310 (FPC 310) and a mother board 320, and the connection structure D using solder being arranged between an electronic component 340 and the mother board 320. The connection structure C using an adhesive is formed with a nonconductive adhesive (NCA).

The mother board 320 includes a rigid printed wiring board 321, an electrode 322 for connection using an adhesive, and an electrode 326 for connection using solder, these electrodes being arranged on the rigid printed wiring board 321. The mother board 320 is a rigid printed wiring board (PWB) corresponding to the display section substrate 135 or the input key board 145 illustrated in Fig. 2. The FPC 310 is mounted on the mother board 320 in such a manner that an electrode 312 for connection using an adhesive (connection conductor) is directed below a base film 311. The electronic component 340 includes a chip 341 having a portion where a chip-side electrode 342 (connection conductor using solder) is arranged, the chip-side electrode 342 being directed below the chip 341.

The electrode 322 for connection using an adhesive and the electrode 326 for connection using solder on the mother board 320 are formed by laminating metallic foil, such as copper foil, on the rigid printed wiring board 321 and subjecting the metallic foil to lithographic exposure and etching in the usual manner.

In the connection structure C using an adhesive, both the electrodes 312 and 322 are tightly contacted by a constricting force of an adhesive 330, which is an NCA, and are conductive with each other. In the connection structure D using solder, by alloying of a solder layer 350 and the electrodes 326 and 342, both the electrodes 326 and 342 are conductive with each other.

The adhesive 330 contains a thermosetting resin, which is a main component, a curing agent, and various types of fillers. The constituents and so forth are the same as those of the adhesive 30 according to the first embodiment, and thus will not be described.

In this embodiment, among the foregoing thermosetting resins, a thermosetting resin having a glass transition temperature of 100°C or higher is used. Examples of the thermosetting resin include epoxy resins, phenolic resins, and polyimide resins.

Before the formation of the connection structure C using an adhesive and the connection structure D using solder, the electrodes 312, 322, 326, and 342 are covered with organic films 315 and 325. The electrode 312 is connected to the electrode 322 with the adhesive 330 to form the connection structure C using an adhesive. Then the electrode 326 is connected to the electrode 342 with the solder layer 350 to form the connection structure D using solder.

Note that other oxidation preventing films, such as gold plating layers, may be formed on the electrodes 312, 322, 326, and 342 in place of the organic films 315 and 325.

To establish a connection using the adhesive 330, the adhesive 330 is melted by heating while the adhesive 330 is pressurized toward the mother board 320 at a predetermined pressure via the FPC 310 (heat and pressure treatment). Thereby, the thermosetting resin in the adhesive 330 is cured, so that the electrodes 312 and 322 on the FPC 310 and the mother board 320, respectively, are tightly contacted by a constricting force due to its contraction and are conductive with each other. In this case, a portion (electrically conductive portion) of the electrode 312 for connection using an adhesive is not covered with the organic film 315, so that electrical conduction is established.

To establish a connection using the solder layer 350, the mother board 320 and the electronic component 340 are placed in a solder reflow furnace having a peak temperature of about 260°C to reflow the solder. At this time, the organic films on the electrode 326 for connection using solder and the chip-side electrode 342 are dissolved in the solder layer 350.

In this embodiment, the electrode 312 for connection using an adhesive on the FPC 310 is processed by etching so as to have a rough surface. Note that machining, such as embossing, may be employed in addition to the etching.

In the case where the electrodes 312 and 322 are covered with the organic films 315 and 325, respectively, when a protruding portion is arranged on a surface of at least one of the electrodes, the protruding portion breaks through the organic films 315 and 325. Hence, the electrodes 312 and 322 are assuredly contacted to each other. A bump may be arranged between the electrodes 312 and 322.

In this embodiment, an increase in connection resistance between the electrodes 312 and 322 for connection using an adhesive before and after the solder reflow treatment is within a predetermined range. Specifically, upon letting the connection resistance between the electrodes 312 and 322 before the solder reflow treatment be $R_1$, upon letting the adhesion strength of the adhesive 330 before the solder reflow treatment be $F_1$, upon letting the connection resistance between the electrodes 312 and 322 after the solder reflow treatment be $R_2$, and upon letting the adhesion strength of the adhesive 330 after the solder reflow treatment be $F_2$, the relational expressions (1) and (2) hold:

$$R_2 < 1.2 \times R_1 \qquad (1)$$

$$F_2 > 0.8 \times F_1 \qquad (2)$$

Specifically, conditions in which the relational expressions (1) and (2) hold are determined by, for example, the selection of the type of thermosetting resin and the setting of the temperature of the solder reflow treatment.

According to the first example, the following effects are provided in addition to the effects of the electrode structure.

Usually, in the case where the connection structure C using an adhesive and the connection structure D using solder are present on a common base material, a procedure is employed in which the solder reflow treatment is first performed to form the connection structure D using solder. This is because if the connection structure C using an adhesive is first formed, the connection resistance can be increased.

In contrast, in this embodiment, the connection is established in such a manner that the increase in connection resistance between the electrodes 312 and 322 before and after the solder reflow treatment is within a predetermined range, for example, in such a manner that relational expression (1) holds. Thus, even if the connection structure C using an adhesive is formed before the formation of the connection structure D using solder, it is possible to suppress the increase in connection resistance between the electrode 312 for connection using an adhesive and the electrode 322 (connection conductor) for connection using an adhesive.

Furthermore, the connection is established in such a manner that a reduction in the constricting force of the adhesive 330 is within a predetermined range, for example, in such a manner that relational expression (2) holds. It is thus possible to suppress the increase in connection resistance (degradation in connection reliability) in long-term use.

Hitherto, the electrodes 312 and 322 for connection using an adhesive have been subjected to gold plating for oxidation prevention. In contrast, the step of forming the organic films by the OSP treatment simplifies the production process, as compared with a step of forming gold plating layers. Furthermore, gold, which is expensive, is not used, reducing material cost. It is thus possible to establish the connection using the adhesive at low cost.

- Connection Structure Using Adhesive According to Second Example of Third Embodiment -

Figure 13 is a cross-sectional view illustrating a connection structure C using an adhesive and a connection structure D using solder according to a second example of the third embodiment. In Fig. 13, the same members as those in Fig. 12 are designated using the same reference numerals, and descriptions are omitted. In the connection structure C using an adhesive, the adhesive 330, which is an anisotropic conductive adhesive (ACA), is used. That is, the adhesive 330 used in this example contains electrically conductive particles 336 in a resin composition 331 mainly composed of a thermosetting resin.

Also in this example, the mother board 320 includes the rigid printed wiring board 321 and the electrode 322 for connection using an adhesive and the electrode 326 for connection using solder, these electrodes being arranged on the rigid printed wiring board 321. Also in this example, a surface of the electrode 312 for connection using an adhesive and a surface of the electrode 322 for connection using an adhesive are covered with the organic films 315 and 325, excluding an electrically conductive portion.

The electrodes 312 and 322 are conductive with each other through the electrically conductive particles 336. The electrically conductive particles 36 are formed of needle-shaped metal powder particles or a metal powder having a form in which many fine metal particles are connected in the form of a straight chain.

Similarly to the first example of the third embodiment, also in this example, the electrodes 312 and 322 may be directly contacted to each other.

Also in this example, before the formation of the connection structure C using an adhesive and the connection structure D using solder, the electrodes 312, 322, 326, and 342 are covered with organic films similar to the organic films 15 illustrated in Fig. 3. In a solder reflow step, the organic films on the electrode 326 for connection using solder and the chip-side electrode 342 are dissolved in the solder layer 350.

When a connection is established, the thermosetting resin in the adhesive 330 is cured by the heat and pressure treatment. The electrodes 312 and 322 are connected to each other through the electrically conductive particles 336 by a constricting force due to its contraction.

In this example, the electrically conductive particles 336 each having a needle shape or having a form in which many fine metal particles are connected in the form of a straight chain are contained in the resin composition 331 from the beginning.

As the anisotropic conductive adhesive used in the second example of the third embodiment, an adhesive the same as that in the foregoing embodiments may be used.

According to the second example of the third embodiment, the connection structure C using an adhesive is first formed under the same conditions as those in the first example of the third embodiment, and then the connection structure D using solder is formed. It is thus possible to provide the same effects as those in the first example of the third embodiment.

Similarly to the foregoing embodiments, as the anisotropic conductive adhesive, an adhesive having the shape illustrated in Fig. 6 may be used. As the metal powder used in the present invention, a metal powder the same as that in the foregoing embodiments may be used.

- Connection Method According to Third Embodiment -

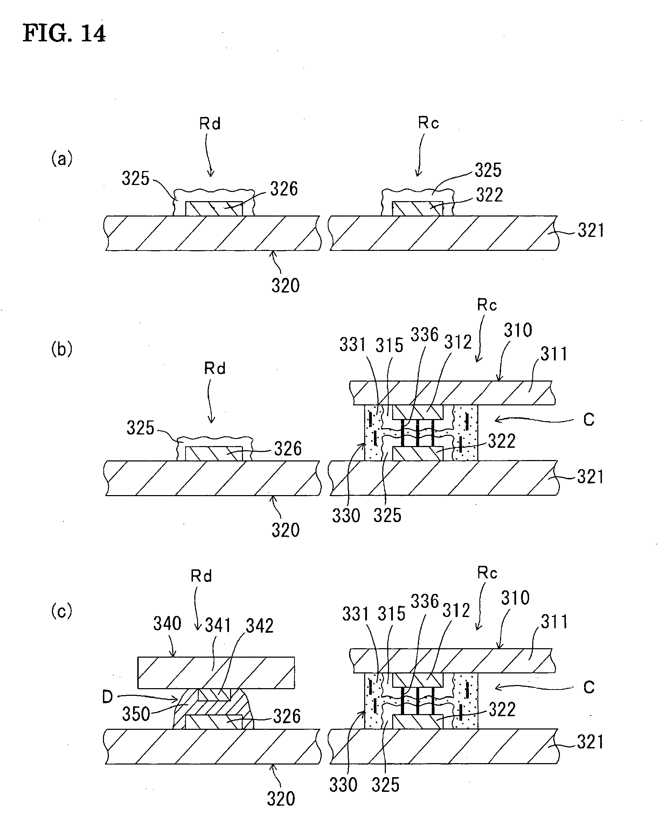

Figures 14(a) to 14(c) are cross-sectional views illustrating the procedure of a connection method for forming a connection structure C using an adhesive and a connection structure D using solder.

In a step illustrated in Fig. 14(a), the mother board 320 (common base material) including a region Rc for connection using an adhesive and a region Rd for connection using solder is prepared. In the mother board 320, the electrode 322 for connection using an adhesive is provided in the region Rc for connection using an adhesive, and the electrode 326 for connection using solder is provided in the region Rd for connection using solder.

Next, the organic films 325 are formed so as to cover the electrodes 322 and 326 for connection using an adhesive.

Next, in a step illustrated in Fig. 14(b), the electrode 322 for connection using an adhesive is bonded to the electrode 312, which is located on the FPC 310, for connection using an adhesive, with the adhesive 330 to establish electrical connection. Thereby, the connection structure C using an adhesive is formed in the region Rc for connection using an adhesive. A procedure for forming the connection structure C using an adhesive is the same as that described in the connection structure using an adhesive according to the second example of the third embodiment (see Fig. 13).

Next, in a step illustrated in Fig. 14(c), the electronic component 340 having the chip-side electrode 342 located in a portion of the chip 341 is arranged in the region Rd for connection using solder. At this point, the chip-side electrode 342 is aligned with the electrode 326 for connection using solder, and lead-free solder is provided between the electrodes 326 and 342. Then the mother board 320 and the electronic component 340 are placed in a solder reflow furnace having a peak temperature of about 260°C to reflow the solder. Thus, the electrodes 326 and 342 are joined to each other through the solder layer 350 to electrically connect the electrodes 326 and 342 to each other.

Thereby, the connection structure D using solder is formed in the region Rd for connection using solder.

The organic film 325 that has covered the electrode 326 for connection using solder reacts with flux contained in the lead-free solder to dissolve into the solder layer 350.

If each of the organic films 315 and 325 has a lower decomposition temperature than the temperature of the solder reflow treatment, the organic films 315 and 325 arranged on the electrodes 312 and 322 for connection using an adhesive are thermally decomposed in the connection structure C using an adhesive by the solder reflow treatment at a temperature equal to or higher than the decomposition temperature. The thermally decomposed organic films 315 and 325 are left in the form of liquid or carbonized powder in the adhesive 330. Alternatively, the organic films 315 and 325 can be thermally decomposed into gaseous products, depending on the material thereof. In any case, after the formation of the connection structure C using an adhesive, there is substantially no increase in connection resistance.

As described above, the adhesive 330 (anisotropic conductive adhesive) containing the electrically conductive particles 336 is mainly composed of a thennosetting resin. Thus, when the anisotropic conductive adhesive is heated, the anisotropic conductive adhesive is temporarily softened. When the heating is continued, the anisotropic conductive adhesive is cured. After a predetermined curing time of the anisotropic conductive adhesive, a pressurized state and a state in which the curing temperature of the anisotropic conductive adhesive is maintained are released, and then cooling is started. Thereby, the electrodes 312 and 322 are connected to each other through the electrically conductive particles 336 in the adhesive 330 to mount the FPC 310 on the mother board 320.

Figures 14(a) to 14(c) illustrate an example of the formation of the connection structure C using an adhesive and the connection structure D using solder on the mother board 320 serving as a PWB.

Alternatively, the FPC 310 may be used as a common base material, and the connection structure C using an adhesive and the connection structure D using solder may be formed on the FPC 310. In that case, the mother board 320 illustrated in Fig. 14 is replaced with the FPC 310, and the organic film 315 is formed on the electrode 312 for connection using an adhesive. The procedure is the same as that described above.

Note that there are a single-sided circuit structure and a double-sided circuit structure in FPCs. For the FPC having the double-sided circuit structure, the FPC is passed through the solder reflow furnace twice.

In the connection method according to the third embodiment, the following effects are provided.

Usually, in the case where connection using solder and connection using an adhesive are performed on the same substrate, after the organic film 325 is formed on the electrode 322 for connection using an adhesive, the connection using solder is first established, and then the connection using an adhesive is established. This is because if the connection using an adhesive is first established, the constriction of the adhesive is loosened during the subsequent solder reflow, so that poor connection is more likely to occur.

Meanwhile, in the case where the connection structure C using an adhesive is formed after the solder reflow step, the connection resistance between the electrodes 312 and 322, which are electrically connected to each other, can be increased, as compared with the case where it is not passed through the solder reflow furnace. This is presumably because the organic films 325 are altered (e.g., hardened) by heating in the solder reflow furnace, so that the electrically conductive particles 336 are less likely to break through the organic films 325.

In the connection method according to this embodiment, the connection structure C using an adhesive is first formed in the step illustrated in Fig. 14(b). Thus, in the step illustrated in Fig. 14(b), the electrically conductive particles 336 break easily through the organic films 315 and 325 and come into contact with the electrodes 312 and 322, so that the electrodes 312 and 322 are conductive with each other.

Meanwhile, the connection is established in such a manner that the increase in connection resistance between the electrodes 312 and 322 before and after the step illustrated in Fig. 14(c) is within a predetermined range, for example, in such a manner that relational expressions (1) and (2) hold. Thus, even if the connection structure C using an adhesive is formed before the formation of the connection structure D using solder, it is possible to suppress the increase in connection resistance and the degradation in reliability between the electrodes 312 and 322 for connection using an adhesive.

Furthermore, the formation of the organic film 325 serving as an oxidation preventing film on the electrode 326 for connection using solder results in improvement in the connection strength (shear strength) between the electrodes 326 and 342.

In summary, in the third embodiment, the following effects are provided.

(1) In the connection structure C using an adhesive according to this embodiment, the surfaces of the electrodes 322, which are located on the mother board 320, for connection using an adhesive and the surfaces of the electrodes 312, which are located on the FPC 310, for connection using an adhesive are subjected to the OSP treatment to form the organic films 315 and 325 serving as oxidation preventing films. According to this structure, a process of forming the oxidation preventing films is simplified, as compared with the case where the electrodes 312 and 322 are covered with gold plating layers. Furthermore, the material cost is reduced, as compared with the case of using a noble metal, such as gold. It is thus possible to connect the electrodes 312 and 322 to each other at low production cost.

Furthermore, the connection using an adhesive and the connection using solder are established in such a manner that the increase in connection resistance between the electrodes 312 and 322 is within a predetermined range, for example, in such a manner that relational expressions (1) and (2) hold. Thus, even if the connection structure C using an adhesive is formed before the formation of the connection structure D using solder, it is possible to suppress the increase in connection resistance between the electrode 312 for connection using an adhesive and the electrode 322 (connection conductor) for connection using an adhesive.

Moreover, the connection using the adhesive 330 is established before the solder reflow treatment. So, there is no need to strictly control the average thickness of each of the organic films 315 and 325 or the area proportion of a region having a small thickness at the time of the OSP treatment.

(2) In this embodiment, the electrically conductive particles 336 in the adhesive 330, which is an anisotropic conductive adhesive, are formed of needle-shaped metal powder particles or a metal powder having a form in which many fine metal particles are connected in the form of a straight chain. According to this structure, the insulation between adjacent electrodes 322 for connection using an adhesive or between adjacent electrodes 312 for connection using an adhesive is maintained to prevent a short circuit with respect to the Y direction, which is the planar direction of the adhesive 330. Furthermore, each of many electrodes 322 for connection using an adhesive is connected to a corresponding one of the electrodes 312 for connection using an adhesive in one operation with respect to the X direction, which is the thickness direction of the adhesive 330, thereby resulting in a low resistance.

(3) In this embodiment, the electrically conductive particles 336 have an aspect ratio of 5 or more. According to this structure, when the anisotropic conductive adhesive is used, the contact probability between the electrically conductive particles 336 is increased. It is thus possible to facilitate electrical connection between the electrodes 312 and 322 without increasing the blending quantity of the electrically conductive particles 336.

(4) In this embodiment, an adhesive having a film-like shape is used as the adhesive 330 (anisotropic conductive adhesive) before the formation of the connection structure C using an adhesive. In this structure, the anisotropic conductive adhesive is easily handled. Furthermore, workability when the connection structure C using an adhesive is formed by the heat and pressure treatment is improved.

(5) In this embodiment, major axes of the electrically conductive particles 336 are oriented in the X direction, which is the thickness direction of the adhesive 330 (anisotropic conductive adhesive) having a film-like shape. According to this structure, the insulation between adjacent electrodes 322 for connection using an adhesive or between adjacent electrodes 312 for connection using an adhesive is maintained to prevent a short circuit with respect to the Y direction, which is the planar direction of the adhesive 330. Furthermore, each of many electrodes 322 for connection using an adhesive is connected to a corresponding one of the electrodes 312 for connection using an adhesive in one operation with respect to the X direction, which is the thickness direction of the adhesive 330, thereby resulting in a low resistance.

(6) In the third embodiment, the flexible printed circuit board (FPC 310) is connected to the rigid printed wiring board (PWB), which is the mother board 320. According to this structure, it is possible to provide a multilayer conductive pattern structure at low cost, as compared with the case where the mother board 320 is an FPC. Furthermore, since the FPC 310 is connected onto the mother board 320, as illustrated in Fig. 2, the flexibility of arrangement of another substrate can be improved when the FPC 10 is connected to a connector of another substrate, as compared with the case where a rigid printed wiring board is connected thereto in place of the FPC 10. In addition, the electrodes 312 and 322 for connection using an adhesive are covered with the organic films 315 and 325 at low cost, as compared with the case where the electrodes 312 and 322 are covered with gold plating films. It is thus possible to provide a connection body of the mother board 320 and the FPC 310 at low cost.

The foregoing embodiment may be changed as described below.

- In the foregoing embodiment, while the rigid printed wiring board (PWB) is used as the mother board 320, another structure may be used. For example, a flexible printed circuit board may be used as the mother board 320.
- In the foregoing embodiment, while the connection structure C using an adhesive is used to connect the electrode of the FPC 310 to the electrode of the mother board 320, which is a PWB, the connection structure using an adhesive of the present invention is not limited thereto. For example, the connection structure C using an adhesive may be used to connect a protruding electrode (or a bump), serving as a conductor, of an electronic component, such as an IC chip, to an electrode on a PWB or FPC.
- A PWB may be mounted on the mother board 320 in place of the FPC 310 according to the foregoing embodiment. Furthermore, an electronic component may be mounted in place of the FPC 310.
- while the electrodes 312 and 322 for connection using an adhesive are subjected to the aqueous preflux treatment serving as the OSP treatment in the foregoing embodiment, heat-resistant preflux treatment may be performed as the OSP treatment. Furthermore, while the acidic aqueous solution containing an azole compound is used in the aqueous preflux treatment, another aqueous solution may be used.

- In the foregoing embodiment, both the electrodes 312 and 322 for connection using an adhesive are subjected to the OSP treatment. However, for example, only one of the electrodes 312 and 322 for connection using an adhesive may be subjected to the OSP treatment. In such a case, a noble metal plating layer, such as a gold plating layer, is formed on the other electrode 322 or 312 for connection using an adhesive. In this case, it is also possible to provide the effect (1) of the foregoing embodiment.

Alternatively, no organic film formed by OSP treatment is arranged, and a gold plating layer may be arranged on each of the electrodes 312, 322, 326, and 342. Examples According to Third Embodiment

The present invention will be described below on the basis of examples and comparative examples according to the third embodiment. The present invention is not limited to these examples. These examples may be modified or altered on the basis of the purpose of the invention. The modifications and alterations are not excluded from the scope of the invention.

(Example 1 According to Third Embodiment)

(Preparation of Adhesive)

The preparation of an adhesive is the same as in Example 1 according to the first embodiment, and the description is omitted. The cured anisotropic conductive adhesive had a glass transition temperature of 115°C.

(Production of Printed Wiring Board)

A flexible printed wiring board in which 30 electrodes for connection using an adhesive, the electrodes being copper electrodes each having a width of 150 $\mu$m, a length of 4 mm, and a height of 18 $\mu$m, were spaced at 150 $\mu$m, was prepared. Oxidation preventing films containing 2-phenyl-4-methyl-5-benzylimidazole were formed by OSP treatment on the electrodes for connection using an adhesive. The oxidation preventing films each had a decomposition temperature of 310°C and an average thickness of 0.10 $\mu$m. The proportion of the area of a region having a thickness of 0.1 $\mu$m or less was 60%.

(Production of Joint Body)

The flexible printed wiring boards were faced to each other in such a manner that a daisy chain in which connection resistances were able to be measured at continuous 30 points was formed. The resulting adhesive was arranged between the flexible printed wiring boards. The flexible printed wiring boards were bonded at 190°C by pressing at a pressure of 5 MPa for 15 seconds, thereby producing a joint body of the flexible printed wiring boards.

(Measurement of Connection Resistance and Adhesion Strength)

In the joint body, resistances at the continuous 30 points connected through the electrodes for connection using an adhesive, the adhesive, and the electrodes for connection using an adhesive were determined by a four-terminal method. The resulting value was divided by 30 to determine a connection resistance per point. It was determined that when the connection resistance was 50 m$\Omega$ or less, the electrical conduction was ensured. The adhesion strength of the resulting joint body was measured by performing peeling at a speed of 50 mm/min and an angle of 90° in the electrode direction. It was determined that when the adhesion strength was 300 N/m or more, satisfactory adhesion strength was obtained.

(Measurement of Connection Resistance and Adhesion Strength After Solder Reflow Treatment)

Next, solder reflow treatment was performed at a peak temperature of 260°C in a solder reflow tank. Then the connection resistance and the adhesion strength were measured in the same way as described above.

(Evaluation of Connection Reliability)

After the resulting connection body was allowed to stand in a high temperature and high humidity tank at 85°C and 85% RH for 500 hr, the connection resistance was measured as described above. It was determined that when the rate of increase in connection resistance was 50% or less, the connection reliability was satisfactory.

(Example 2 According to Third Embodiment)

A joint body of flexible printed wiring boards was produced as in Example 1, except that the oxidation preventing films each had an average thickness of 0.60 $\mu$m and that the proportion of the area of a region having a thickness of 0.1 $\mu$m or less was 2%. Then the evaluation of the connection resistance and the evaluation of the connection reliability were made under conditions the same as those of Example 1.

(Comparative Example 1)

A joint body of flexible printed wiring boards was produced as in Example 1 according to the third embodiment, except that the adhesive contained the components in a weight ratio of (1)35/(2)20/(3)0/(4)20/(5)5. The cured adhesive had a glass transition temperature of 80°C.

(Measurement of Decomposition Temperature)

The decomposition temperature was measured with a differential scanning calorimetry (DSC). An exothermic onset temperature at a heating rate of 10 °C/min is defined as a decomposition temperature.

(Thickness Measurement)

Cross sections of the electrodes for connection using an adhesive are observed, the electrodes being covered with the oxidation preventing films. The thicknesses were measured at intervals of 0.2 $\mu$m, and then the proportion of the area of a region having an average thickness of 0.1 $\mu$m or less is calculated.

(Measurement of Glass Transition Temperature of Adhesive)

The glass transition temperature of the adhesive was measured with a dynamic viscoelastometer after the adhesive was completely cured. When the measurement is performed at a rate of temperature increase of 10 °C/min and a frequency of 1 Hz, a temperature at which tan $\delta$ is maximized is defined as a glass transition temperature.

[Table 3]

| | Initial connection resistance (m$\Omega$) | Initial adhesion strength (N/m) | Connection resistance after reflow (m$\Omega$) | Adhesion strength after reflow (N/m) | Rate of increase in resistance (%) |
|---|---|---|---|---|---|
| Example 1 | 42 | 620 | 43 | 600 | 3 |
| Example 2 | 43 | 680 | 45 | 650 | 5 |
| Comparative Example 1 | 49 | 320 | 150 | 120 | $\infty$ |

Table 3 shows the results of the evaluations of the connection resistance, the adhesion strength, and the connection reliability in Examples 1 and 2 according to the third embodiment and the comparative example.

As shown in Table 3, in each of the Examples 1 and 2 according to the third embodiment, the initial connection resistance is 50 m$\Omega$ or less. The connection resistance is sufficiently small, which is satisfactory. Furthermore, in each of Examples 1 and 2 according to the third embodiment, the rate of increase in resistance is 50% or less. This demonstrates that the connection reliability is also satisfactory.

In Example 1 according to the third embodiment, before the solder reflow treatment, the connection resistance $R_1$ is 42 (m$\Omega$), and the adhesion strength $F_1$ of the adhesive is 620 (N/m). After the solder reflow treatment, the connection resistance $R_2$ is 43 (m$\Omega$), and the adhesion strength $F_2$ of the adhesive is 600 (N/m). Thus, relational expressions (1) and (2) are satisfied as follows:

$$R_2 = 43 < 1.2 \times R_1 = 1.2 \times 42 = 50.4 \qquad (1)$$

$$F_2 = 600 > 0.8 \times F_1 = 0.8 \times 620 = 496 \qquad (2)$$

Similarly, in Example 2 according to the third embodiment, before the solder reflow treatment, the connection resistance $R_1$ is 43 (mΩ), and the adhesion strength $F_1$ of the adhesive is 680 (N/m). After the solder reflow treatment, the connection resistance $R_2$ is 45 (mΩ), and the adhesion strength $F_2$ of the adhesive is 650 (N/m). Thus, the relational expressions (1) and (2) are satisfied as described below:

$$R_2 = 45 < 1.2 \times R_1 = 1.2 \times 43 = 51.6 \qquad (1)$$

$$F_2 = 650 > 0.8 \times \quad F_1 = 0.8 \times 680 = 544 \qquad (2)$$

That is, in Examples 1 and 2 according to the third embodiment, the increase in connection resistance is within the predetermined range.

In Comparative Example 1, although the initial connection resistance is relatively high, the electrical conduction is barely achieved. However, after the solder reflow treatment, the connection resistance exceeds 50 (mΩ), and the rate of increase in resistance is ∞ (infinite).

Furthermore, in Comparative Example 1, before the solder reflow treatment, the connection resistance $R_1$ is 49 (mΩ), and the adhesion strength $F_1$ of the adhesive is 320 (N/m). After the solder reflow treatment, the connection resistance $R_2$ is 150 (mΩ), and the adhesion strength $F_2$ of the adhesive is 120 (N/m). In this case, relational expressions (1) and (2) are not satisfied as described below:

$$R_2 = 150 > 1.2 \times R_1 = 1.2 \times 49 = 58.8$$

$$F_2 = 120 < 0.8 \times F_1 = 0.8 \times 320 = 256$$

That is, in Comparative Example 1, the increase in connection resistance is not within the predetermined range.

The reason for this is presumably that the adhesion strength of the adhesive was reduced from 320 (N/m) to 120 (N/m) by the solder reflow treatment, i.e., a reduction in the constricting force of the adhesive degrades the conductivity owing to the electrically conductive particles. That is, the adhesive has a composition in which relational expressions (1) and (2) are not satisfied, thereby leading to the degradation in connection reliability.

Furthermore, comparisons of Examples 1 and 2 according to the third embodiment show substantially the same connection resistance and substantially the same rate of increase in resistance. The results thus demonstrate that as described in Example 2, even at an average thickness of 0.5 μm or more and a small area proportion of a region having a thickness of 0.1 μm or less, the adhesive having a composition such that relational expressions (1) and (2) hold provides high connection reliability.

It should be understood that the structures of the embodiments disclosed herein are merely illustrative. The scope of the present invention is not limited to the scope of the description. The scope of the present invention is shown by the scope of the claims, and is intended to include all modifications within the equivalent meaning and scope of the claims.

Industrial Applicability

The electrode structure, the wiring body, and the connection structure using an adhesive of the present invention are usable for electrode structures and connection structures of members arranged in electronic devices, such as cellular phones, cameras, e.g., digital cameras and video cameras, portable audio players, portable DVD players, and portable notebook personal computers. Furthermore, a release sheet body of the present invention is usable for connection of various wiring boards, such as FPCs and rigid printed circuit boards (PCBs), and various electronic components.

Reference Signs List

| | |
|---|---|
| 10 | FPC |
| 11 | base film |
| 12 | electrode for connection using adhesive (connection conductor) |
| 13 | coverlay |
| 15 | organic film |
| 20 | mother board |
| 21 | rigid printed wiring board |
| 22 | electrode for connection using adhesive |
| 26 | electrode for connection using solder |
| 30 | adhesive |
| 31 | resin composition |
| 36 | electrically conductive particles |
| 40 | electronic component |
| 41 | chip |
| 42 | chip-side electrode (connection conductor using solder) |
| 50 | solder layer |

**Claims**

1. A connection method comprising:

   a step (a1) of preparing a base material including an electrode for connection using an adhesive and a conductor for connection using solder;
   a step (b1) of covering the electrode for connection using an adhesive with an organic film configured to prevent oxidation, the electrode being arranged on the base material;
   after the step (b1) and before the step (c1), a step (e1) of joining the conductor for connection using solder to a connection conductor using solder by solder reflow treatment in a non-oxidizing atmosphere;
   a step (c1) of removing or thinning the organic film; and
   after the step (c1), a step (d1) of bonding the electrode for connection using an adhesive to a connection conductor with an adhesive having as a main component a thermosetting resin to establish electrical connection wherein the organic film has a higher decomposition temperature than a solder reflow temperature of the solder reflow treatment.

2. The connection method according to Claim 1,
   wherein in the step (c1), the organic film is brought into contact with an acidic solution or its vapor.

3. The connection method according to Claim 1 or 2,
   wherein an anisotropic conductive adhesive containing electrically conductive particles is used as the adhesive.

4. The connection method according to Claim 3,
   wherein the adhesive contains electrically conductive particles formed of needle-shaped metal powder particles or a metal powder having a form in which a plurality of metal particles are connected in the form of a chain.

**5.** The connection method according to Claim 4,
wherein each of the electrically conductive particles has an aspect ratio of 5 or more.

**6.** The connection method according to any one of Claims 1 to 5,
wherein the adhesive has a film-like shape.

**7.** The connection method according to Claim 6,
wherein the adhesive contains electrically conductive particles whose major axes are oriented in the thickness direction of the adhesive having a film-like shape.

**8.** The connection method according to any one of Claims 1 to 7,
wherein a flexible printed wiring board is prepared as the base material.

**9.** A method of assembling an electronic device, including forming connections between an electrode and a connection conductor of the device using the connection method according to any one of Claims 1 to 8.

**Patentansprüche**

**1.** Verbindungsverfahren, umfassend:

einen Schritt (a1) des Präparierens eines Basismaterials, das eine Elektrode zum Anschließen unter Verwendung eines Klebstoffes und einen Leiter zum Anschließen unter Verwendung einer Lötpaste beinhaltet;
einen Schritt (b1) des Bedeckens der Elektrode zum Anschließen unter Verwendung eines Klebstoffes mit einem organischen Film, der zum Verhindern einer Oxidation dient, wobei die Elektrode auf dem Basismaterial angeordnet wird;
nach dem Schritt (b1) und vor dem Schritt (c1), ein Schritt (e1) des Verbindens des Leiters zum Anschließen unter Verwendung einer Lötpaste mit einem Verbindungsleiter unter Verwendung einer Lötpaste mittels einer Lötpasten-Reflow-Behandlung in einer nichtoxidierenden Atmosphäre;
einen Schritt (c1) des Entfernens oder Ausdünnens des organischen Filmes; und
nach dem Schritt (c1) einen Schritt (d1) des Verbindens der Elektrode zum Anschließen unter Verwendung eines Klebstoffes mit einem Verbindungsleiter durch einen Klebstoff, der als Hauptbestandteil ein Termosetting-Harz aufweist, um eine elektrische Verbindung herzustellen,
wobei der organische Film eine höhere Zerfallstemperatur als eine Lötpasten-Reflow-Temperatur der Lötpasten-Reflow-Behandlung aufweist.

**2.** Verbindungsverfahren nach Anspruch 1,
wobei bei dem Schritt (c1) der organische Film in Kontakt mit einer sauren Lösung oder deren Dampf gebracht wird.

**3.** Verbindungsverfahren nach Anspruch 1 oder 2,
wobei ein anisotroper leitender Klebstoff, der elektrisch leitende Teilchen enthält, als Klebstoff verwendet wird.

**4.** Verbindungsverfahren nach Anspruch 3,
wobei der Klebstoff elektrisch leitende Teilchen enthält, die aus nadelförmigen Metallpulverteilchen oder einem Metallpulver mit einer Form gebildet sind, bei der eine Mehrzahl von Metallteilchen in Form einer Kette verbunden ist.

**5.** Verbindungsverfahren nach Anspruch 4,
wobei jedes der elektrisch leitenden Teilchen ein Längenverhältnis von 5 oder mehr aufweist.

**6.** Verbindungsverfahren nach einem der Ansprüche 1 bis 5,
wobei der Klebstoff eine filmartige Form aufweist.

**7.** Verbindungsverfahren nach Anspruch 6,
wobei der Klebstoff elektrisch leitfähige Teilchen enthält, deren Hauptachsen in der Dickenrichtung des Klebstoffes mit filmartiger Form ausgerichtet sind.

**8.** Verbindungsverfahren nach einem der Ansprüche 1 bis 7,
wobei eine flexible bedruckte Leiterplatte als Basismaterial präpariert wird.

**9.** Verfahren zum Zusammensetzen einer elektronischen Vorrichtung, beinhaltend ein Bilden von Verbindungen zwischen einer Elektrode und einem Verbindungsleiter der Vorrichtung unter Verwendung des Verbindungsverfahrens nach einem der Ansprüche 1 bis 8.

**Revendications**

**1.** Procédé de connexion comprenant :

une étape (a1) de préparation d'un matériau de base comprenant une électrode pour une connexion en utilisant un adhésif et un conducteur pour une connexion en utilisant une soudure ;
une étape (b1) de revêtement de l'électrode pour une connexion en utilisant un adhésif avec un film organique configuré pour éviter une oxydation, l'électrode étant agencée sur le matériau de base ;
après l'étape (b1) et avant l'étape (c1), une étape (e1) de jonction du conducteur pour une connexion en utilisant une soudure à un conducteur de connexion en utilisant une soudure par un traitement de refusion de soudure dans une atmosphère non oxydante ;
une étape (c1) de retrait ou d'amincissement du film organique ; et
après l'étape (c1), une étape (d1) de liaison de l'électrode pour une connexion en utilisant un adhésif à un conducteur de connexion avec un adhésif ayant en tant que composant principal une résine thermodurcissable pour établir une connexion électrique,
dans lequel le film organique a une température de décomposition supérieure à une température de refusion de soudure du traitement de refusion de soudure.

**2.** Procédé de connexion selon la revendication 1,
dans lequel, à l'étape (c1), le film organique est mis en contact avec une solution acide ou avec sa vapeur.

**3.** Procédé de connexion selon la revendication 1 ou 2,
dans lequel un adhésif conducteur anisotrope contenant des particules électriquement conductrices est utilisé en tant qu'adhésif.

**4.** Procédé de connexion selon la revendication 3,
dans lequel l'adhésif contient des particules électriquement conductrices constituées de particules de poudre métallique en forme d'aiguilles ou une poudre métallique ayant une forme dans laquelle une pluralité de particules métalliques sont reliées sous la forme d'une chaîne.

**5.** Procédé de connexion selon la revendication 4,
dans lequel chacune des particules électriquement conductrices a un rapport d'aspect de 5 ou plus.

**6.** Procédé de connexion selon l'une quelconque des revendications 1 à 5,
dans lequel l'adhésif a une forme similaire à un film.

**7.** Procédé de connexion selon la revendication 6,
dans lequel l'adhésif contient des particules électriquement conductrices dont les axes principaux sont orientés dans la direction d'épaisseur de l'adhésif ayant une forme similaire à un film.

**8.** Procédé de connexion selon l'une quelconque des revendications 1 à 7,
dans lequel une carte de câblage imprimée souple est préparée en tant que matériau de base.

**9.** Procédé d'assemblage d'un dispositif électronique, comprenant la formation de connexions entre une électrode et un conducteur de connexion du dispositif en utilisant le procédé de connexion selon l'une quelconque des revendications 1 à 8.

FIG. 1

# FIG. 2

## FIG. 3

## FIG. 4

## FIG. 5

FIG. 6

# FIG. 7

FIG. 8

FIG. 9

# FIG. 10

# FIG. 11

(a)

Rd     Rc

225     226     222

221

220

(b)

Rd     Rc

240   241   242     222a

D     222

250     226     221

220

(c)

Rd     Rc

240   241   242

D     222

250     226     221

220

(d)

Rd     Rc

240   241   242     231 215 236 212 210 211

D     C

250     226     222

220     221

230

# FIG. 12

# FIG. 13

# FIG. 14

(a)

(b)

(c)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10079568 A
- US 5611140 A
- DE 102005031181 A
- US 6375060 B
- JP 2008308519 A
- US 20020023342 A